(19) Europäisches Patentamt / European Patent Office / Office européen des brevets

(11) **EP 2 739 985 B1**

(12) **FASCICULE DE BREVET EUROPEEN**

(45) Date de publication et mention
de la délivrance du brevet:
**30.08.2017 Bulletin 2017/35**

(21) Numéro de dépôt: **12744101.2**

(22) Date de dépôt: **24.07.2012**

(51) Int Cl.:
***G01R 33/385*** (2006.01)  ***G01R 33/3875*** (2006.01)

(86) Numéro de dépôt international:
**PCT/FR2012/051756**

(87) Numéro de publication internationale:
**WO 2013/017777 (07.02.2013 Gazette 2013/06)**

(54) **PROCÉDÉ ET SYSTÈME DE GÉNÉRATION DE GRADIENTS DE CHAMP MAGNÉTIQUE POUR MACHINE D'IMAGERIE A RMN**

VERFAHREN UND SYSTEM ZUR ERZEUGUNG VON MAGNETFELDGRADIENTEN FÜR EIN NMR-BILDGEBUNGSGERÄT

METHOD AND SYSTEM FOR GENERATING MAGNETIC FIELD GRADIENTS FOR AN NMR IMAGING MACHINE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **01.08.2011 FR 1157029**

(43) Date de publication de la demande:
**11.06.2014 Bulletin 2014/24**

(73) Titulaires:
• **Commissariat à l'Énergie Atomique et aux Énergies Alternatives**
**75015 Paris (FR)**
• **Aubert, Guy G.**
**86000 Poitiers (FR)**

(72) Inventeur: **AUBERT, Guy G.**
**F-86000 Poitiers (FR)**

(74) Mandataire: **Desormiere, Pierre-Louis et al**
**Cabinet Beau de Loménie**
**158, rue de l'Université**
**75340 Paris Cedex 07 (FR)**

(56) Documents cités:

| | |
|---|---|
| EP-A1- 0 221 810 | EP-A2- 0 140 259 |
| WO-A1-89/03031 | WO-A2-2005/029110 |
| WO-A2-2007/048983 | FR-A1- 2 892 524 |
| US-A- 4 617 516 | US-A- 5 530 355 |

## Description

Domaine de l'invention

La présente invention a pour objet un procédé et un système de génération de gradients de champ magnétique pour créer un gradient de champ magnétique dans un volume d'intérêt d'une machine de résonance magnétique nucléaire (RMN) ou d'imagerie par résonance magnétique (IRM) à aimant supraconducteur.

L'invention concerne également une machine d'imagerie par résonance magnétique nucléaire à gradients améliorés.

Art antérieur

Un appareil d'imagerie par résonance magnétique nucléaire comporte essentiellement trois types de bobines ou équivalents.

Un premier type de bobines, qui peut être remplacé par un aimant permanent, a pour objet de créer un champ magnétique principal homogène intense $B_0$ dans un volume d'intérêt prédéterminé. Par champ magnétique intense, on entend un champ magnétique au moins égal à 0,5T, de préférence supérieur ou égal à 1T, et qui dans certaines réalisations peut dépasser 10T, pour des applications de RMN ou d'IRM. La première bobine peut par exemple être constituée par une bobine supraconductrice d'aimantation principale placée dans un cryostat.

Un deuxième type de bobines, dites radiofréquence, a pour but de soumettre un corps ou objet examiné et placé sous l'influence du champ principal des premières bobines, ou de l'aimant permanent, à des séquences d'excitation radiofréquence, et de mesurer un signal radiofréquence réémis en retour par des particules du corps ou de l'objet examiné. La réponse radiofréquence est une réponse en volume : toutes les particules d'une région du corps soumises à l'examen émettent en même temps leur réponse radiofréquence. Pour créer une image, il est nécessaire de différencier ces réponses.

Un troisième type de bobines, dites de gradient permet précisément de superposer au champ principal intense $B_0$ des composantes d'un champ magnétique supplémentaire. La valeur de ces composantes est fonction des coordonnées dans l'espace de leur lieu d'application. Classiquement, on organise cette différenciation selon trois axes orthogonaux X, Y, Z. Par convention, l'axe Z est généralement pris colinéaire au champ intense $B_0$ créé par le premier type de bobines ou l'aimant permanent. Chaque lieu de l'espace peut ainsi être codé par une valeur de champ différente et on exploite dans le signal réémis les modifications qui en résultent pour créer l'image.

L'acquisition d'une image nécessite donc au cours de l'application des séquences d'excitation radiofréquence, l'excitation conjointe de séquences de gradients de champ qui sont pulsés.

Le document EP-A-221810 présente des rappels concernant l'IRM et indique comment calculer des gradients qui soient les plus linéaires possibles compte tenu d'un encombrement donné, notamment pour des bobines de gradient selon X ou selon Y, dites en selle de cheval, qui constituent des bobines de gradient classiques.

D'une manière générale, un problème à résoudre consiste, pour un emplacement donné, à trouver des bobines de gradient qui produisent un gradient suffisamment fort et homogène et dont la self inductance soit faible. Ceci constitue des exigences contradictoires. En effet, pour que l'imagerie RMN soit de qualité, il convient que les gradients de champ réels soient homogènes, c'est-à-dire respectent, avec une tolérance donnée, une distribution théorique idéale que l'on voudrait imposer. Pour accroître l'homogénéité des gradients produits, les bobines de gradient doivent être les plus grandes possibles, mais il convient également, pour des questions d'encombrement et de puissance, de ne pas augmenter exagérément la taille de ces bobines.

Par ailleurs, comme indiqué dans le document WO 89/03031, des écrans de protection sont le siège de courants de Foucault et nécessitent la mise en oeuvre de dispositions particulières dans les bobines de gradient pour tenter de réduire l'influence de ces courants de Foucault qui tendent à s'opposer à l'établissement du champ magnétique supplémentaire de gradient désiré.

Dans le document WO 2005/029110, notamment en vue de réduire le bruit créé par des bobines de gradient conçues pour des machines de RMN du type tunnel créant un champ orienteur intense, on a proposé, pour réaliser les gradients, de consacrer l'espace annulaire disponible à la mise en place de tubes d'axes parallèles au champ principal dans lesquels sont engagées des bobines solénoïdales circulaires qui sont ainsi substituées aux bobines de gradient classiques en forme de selle de cheval. Les tubes peuvent être contigus les uns aux autres pour former une nappe de tubes.

La disposition des bobines solénoïdales circulaires dans des tubes permet généralement d'aboutir au résultat escompté de grande intensité des gradients produits, grâce à des possibilités de refroidissement améliorées, de respect des contraintes de linéarité imposées par les spécifications, de réduction des bruits acoustiques et dans une certaine mesure de limitation des courants de Foucault.

Toutefois, ces courants de Foucault peuvent dans certains cas rester gênants, notamment en provoquant un échauffement exagéré du cryostat de l'aimant principal, qui augmente la consommation de fluide cryogénique, et l'interposition d'écrans entre des générateurs de gradients et le cryostat contribue à diminuer l'efficacité des gradients, même si elle permet de diminuer vers l'extérieur les champs électriques produits par les générateurs de gradients.

Pour remédier à ces inconvénients, dans le document WO 2007/048983, on a proposé de réaliser un premier ensemble de bobines de gradient solénoïdales placées dans des tubes disposés dans un premier espace annulaire cylindrique et un deuxième ensemble de bobines de gradient solénoïdales de compensation placées dans des tubes disposés dans un deuxième espace annulaire cylindrique coaxial au premier espace annulaire cylindrique et situé entre une enceinte cryogénique extérieure et le premier espace annulaire cylindrique, les sens de circulation des courants pulsés étant inversés dans les bobines du deuxième ensemble par rapport à celui des bobines du premier ensemble.

La présence du deuxième ensemble de bobines de gradient permet de réduire de façon efficace les courants induits et de limiter la distorsion des gradients que l'on souhaite produire, mais l'encombrement total est important, ce qui d'un point de vue pratique constitue un inconvénient.

Ces systèmes de l'art antérieur réalisent la compensation par deux ensembles de bobines du même type, soit classiques pour le système décrit dans le document WO 89/03031, soit « en tubes » pour le système précédent. Comme les bobines sont de même type, il en résulte nécessairement un affaiblissement du gradient que créeraient les bobines primaires seules

et la valeur souhaitée du gradient (par exemple des gradients de l'ordre de 70 mT/m) ne peut être obtenue qu'en sacrifiant la linéarité.

## Définition et objet de l'invention

La présente invention vise à remédier aux inconvénients précités et à permettre la satisfaction d'exigences contradictoires en permettant d'obtenir une machine compacte, avec des gradients de champ magnétique de valeur nominale élevée, qui présentent cependant une excellente linéarité, avec un blindage efficace qui limite les courants induits dans les enveloppes conductrices extérieures, avec une résistance électrique et une inductance qui soient minimales et avec des bruits et vibrations également réduits.

L'invention vise encore à définir un procédé de réalisation d'un tel dispositif qui soit simplifié et permette néanmoins de satisfaire les exigences contradictoires mentionnées ci-dessus.

L'invention consiste schématiquement à réaliser un système hybride en combinant un premier ensemble de bobines classiques avec un second ensemble de bobines « en tubes » dont les gradients se renforcent mutuellement au lieu de s'affaiblir dans le volume d'intérêt, alors qu'ils réalisent à l'extérieur la compensation nécessaire à l'atténuation des courants de Foucault.

Ces buts sont atteints, conformément à l'invention, grâce à un système de génération de gradients de champ magnétique, disposé autour d'un volume d'intérêt (ZI) d'axe Oz dans une machine d'imagerie par résonance nucléaire tel que défini par la revendication indépendante 1. Les revendications 2 à 6 définissent des modes de réalisation préférentiels. L'invention concerne également une machine d'imagerie par résonance magnétique nucléaire à gradients améliorés telle que définie par la revendication indépendante 7. La revendication 8 définit un mode de réalisation préférentiel. L'invention concerne également un procédé de réalisation d'un système de génération de gradients de champ magnétique, disposé autour d'un volume d'intérêt (ZI) d'axe Oz dans une machine d'imagerie par résonance nucléaire tel que défini par la revendication indépendante 9. La revendication 10 définit un mode de réalisation préférentiel.

## Brève description des dessins

D'autres caractéristiques et avantages de l'invention ressortiront de la description suivante de modes particuliers de réalisation de l'invention donnés à titre d'exemples en référence aux dessins annexés, sur lesquels :

- La figure 1 représente une vue schématique en coupe axiale d'un premier exemple de dispositif de production de gradient z hybride de champ magnétique pouvant être inclus dans un système de génération de champ magnétique selon l'invention,
- La figure 1A représente de façon agrandie une partie de la figure 1,
- La figure 2 représente une vue schématique en coupe axiale d'un deuxième exemple de dispositif de production de gradient z hybride de champ magnétique pouvant être inclus dans un système de génération de champ magnétique selon l'invention,
- La figure 2A représente de façon agrandie une partie de la figure 2,
- La figure 3 représente de façon agrandie une partie de la figure 2A,
- La figure 4 est une vue schématique en coupe perpendiculaire à l'axe montrant les différents sous-ensembles composant un système de génération de gradients hybrides selon l'invention,
- La figure 5 représente une partie agrandie de la figure 4,

- La figure 5A représente de façon encore plus agrandie une partie de la figure 5,
- La figure 6 est une vue schématique en perspective de l'ensemble d'un système de génération de gradients hybrides selon l'invention,
- La figure 7 est une vue en coupe selon le plan VII-VII de la figure 6,
- La figure 8 est une vue schématique en perspective d'une partie du système de génération de gradients hybrides de la figure 6 comprenant un premier dispositif de création de gradients x et y en forme de « selles de cheval » et un dispositif complémentaire de création de gradients x et y à l'aide de bobines solénoïdales « en tubes »,
- La figure 9 est une vue schématique en perspective d'une partie du système de génération de gradients hybrides de la figure 6 comprenant un premier dispositif de création de gradients x et y en forme de « selles de cheval »,
- La figure 10 est une vue schématique en perspective d'une partie du système de génération de gradients hybrides de la figure 6 comprenant un premier dispositif de création de gradient z à l'aide de bobines classiques et un dispositif complémentaire de création de gradient z à l'aide de bobines solénoïdales « en tubes »,
- Les figures 11 et 12 représentent en vue développée en plan deux exemples possibles de réalisation de bobines en forme de selle de cheval utilisables dans le cadre du premier dispositif de création de gradients x et y,
- Les figures 13 à 18 représentent divers exemples de réalisation de transitions inter-spires pour des bobines en forme de selle de cheval telles que celles des figures 11 et 12 ou des bobines solénoïdales, et
- La figure 19 représente de façon schématique un exemple de machine d'imagerie par résonance magnétique nucléaire selon l'art antérieur à laquelle est applicable l'invention.

Rescription détaillée de modes de réalisation préférentiels

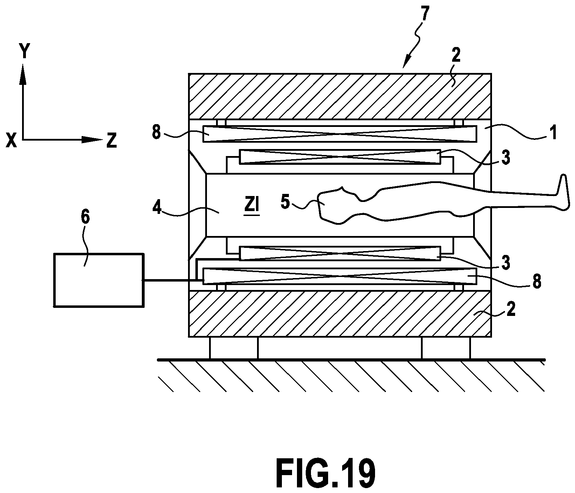

On rappellera d'abord en référence à la figure 19 le principe d'une machine 7 d'imagerie par résonance magnétique (IRM) à laquelle est applicable l'invention.

Une zone annulaire cylindrique extérieure 2 incorpore un dispositif de création d'un champ magnétique principal homogène et intense $B_0$ essentiellement parallèle à l'axe z d'un tunnel 4 dans lequel est installé un patient 5 ou un objet à examiner.

Le dispositif de création d'un champ magnétique principal homogène et intense $B_0$ comprend de façon privilégiée un aimant supraconducteur placé dans un cryostat destiné à maintenir cet aimant supraconducteur à très basse température. Dans tous les cas, le dispositif de création d'un champ magnétique intense est placé dans l'enceinte externe annulaire cylindrique 2 qui ménage un espace annulaire cylindrique 1 entre la paroi interne de cette enceinte externe 2 et le tunnel 4.

Un système 8 de génération de gradients de champ magnétique à la fois selon la direction de l'axe z du tunnel et selon les directions x et y perpendiculaires entre elles et à l'axe z est disposé dans l'espace annulaire 1.

Comme on l'a indiqué précédemment, les bobines du générateur de gradients 8 servent à créer un codage dans l'espace où se trouve le patient 5 par l'application de champs magnétiques supplémentaires pulsés.

Les composantes de ces champs qui ne sont pas orientés comme le champ orienteur $B_0$ contribuent au deuxième ordre seulement (et donc de manière négligeable pour les valeurs considérées de $B_0$ et des gradients) à la modification du signal de RMN utile. Ainsi, la seule composante de ces champs magnétiques produite par les bobines de gradient, qui est intéressante et utile est la composante orientée selon le champ $B_0$. Cette composante utile est appelée traditionnellement composante Bz. La machine est repérée par rapport à un référentiel cartésien, l'axe z étant colinéaire à la direction du champ uniforme $B_0$ et parallèle aux génératrices de la machine tunnel. Selon les différents jeux de bobines de gradient alimentés, la composante Bz utile en un lieu verra son amplitude croître en fonction de l'abscisse x d'un plan contenant ce lieu, parallèle au plan yOz pour les gradients x, en fonction de l'ordonnée y d'un plan contenant ce lieu, parallèle au plan xOz pour les gradients y, ou en fonction de la cote z d'un plan contenant ce lieu, parallèle au plan xOy pour les gradients z.

Un dispositif 3 d'antennes d'émission radiofréquence est disposé au voisinage du tunnel 4 ou est inséré directement dans ce tunnel. Les bobines ou antennes d'émission radiofréquence sont associées de façon classique à des dispositifs de réception et de traitement des signaux radiofréquence émis en réponse par le corps du patient 5 ou tout autre objet étudié, tel qu'un animal par exemple.

On a représenté de façon symbolique sur la figure 19 un dispositif 6 d'alimentation électrique des bobines de gradient du système 8 de génération de gradients et du dispositif 3 d'antennes d'émission radiofréquence.

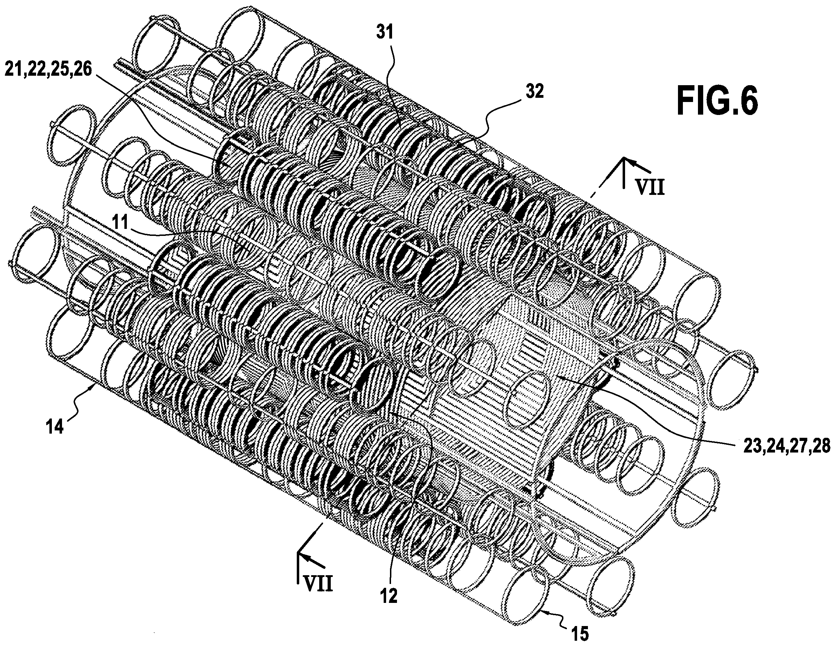

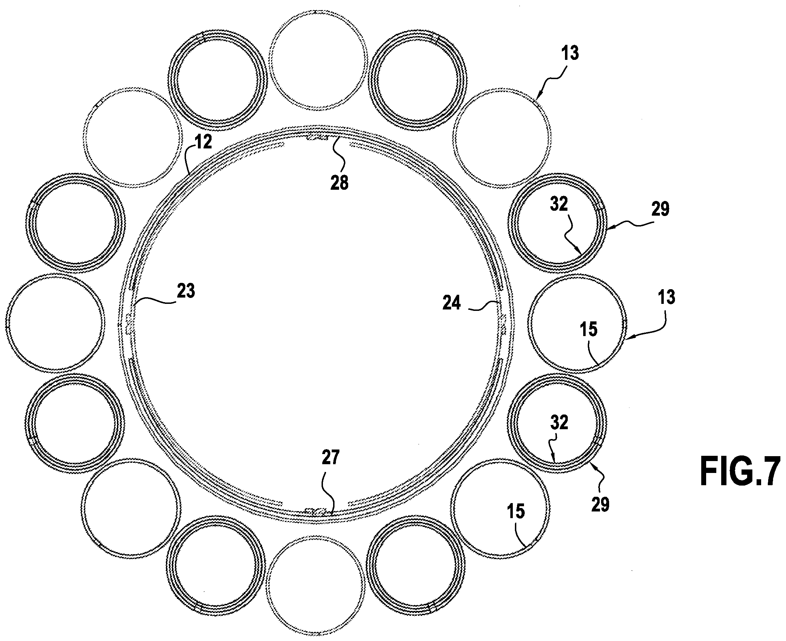

Les figures 6 et 7 permettent de voir l'ensemble des différents éléments composant un système 8 de génération de gradients de champ magnétique selon l'invention pouvant être intégré dans un espace annulaire cylindrique tel que l'espace 1 de la machine d'IRM 7 représentée schématiquement sur la figure 19.

Le système 8 de génération de gradients comprend en premier lieu, à l'intérieur de l'espace annulaire cylindrique 1, des première et deuxième bobines solénoïdales 11, 12 de gradient z comprenant chacune une même pluralité n1 de spires identiques d'axe Oz et de diamètre inférieur au diamètre externe de l'espace annulaire cylindrique 1, les spires de la deuxième bobine 12 étant parcourues par un courant de sens opposé à celui parcourant les spires de la première bobine 11 pour produire une première composante de gradient de champ z dans une direction axiale z parallèle à l'axe Oz.

Le système 8 de génération de gradients comprend en second lieu un ensemble de N1 premiers tubes 13 non jointifs identiques d'axes parallèles à l'axe Oz et disposés dans un sous-espace annulaire cylindrique 9 situé à l'intérieur de l'espace annulaire cylindrique 1 à l'extérieur des première et deuxième bobines 11, 12 de gradient z, chacun des N1 premiers tubes 13 comprenant des troisième et quatrième bobines solénoïdales 14, 15 de gradient z symétriques par rapport à un plan xOy perpendiculaire à l'axe Oz, comprenant chacune une même pluralité n2 de spires identiques de diamètre inférieur au diamètre interne du tube correspondant 13 et réparties dans des positions prédéterminées selon l'axe de ce tube 13, les spires de la quatrième bobine 15 disposée en regard de la deuxième bobine 12 étant parcourues par un courant de sens opposé à celui parcourant les spires de la deuxième bobine 12 et à celui parcourant les spires de la troisième bobine 14 elle-même disposée en regard de la première bobine 11 pour produire une deuxième composante de gradient de champ z dans la direction axiale z parallèle à l'axe Oz.

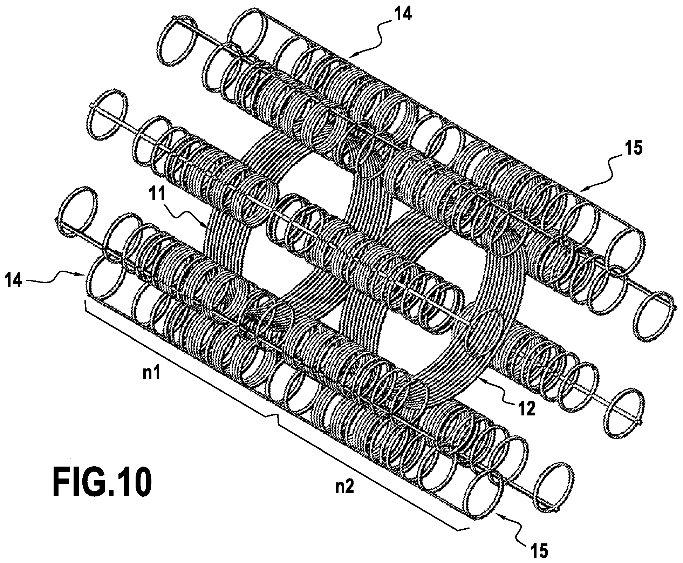

La figure 10 montre en perspective un exemple de bobines 11 et 12 coopérant avec une pluralité de couples de bobines 14, 15 disposées en couronne autour des bobines 11 et 12 et représentées sans les tubes 13.

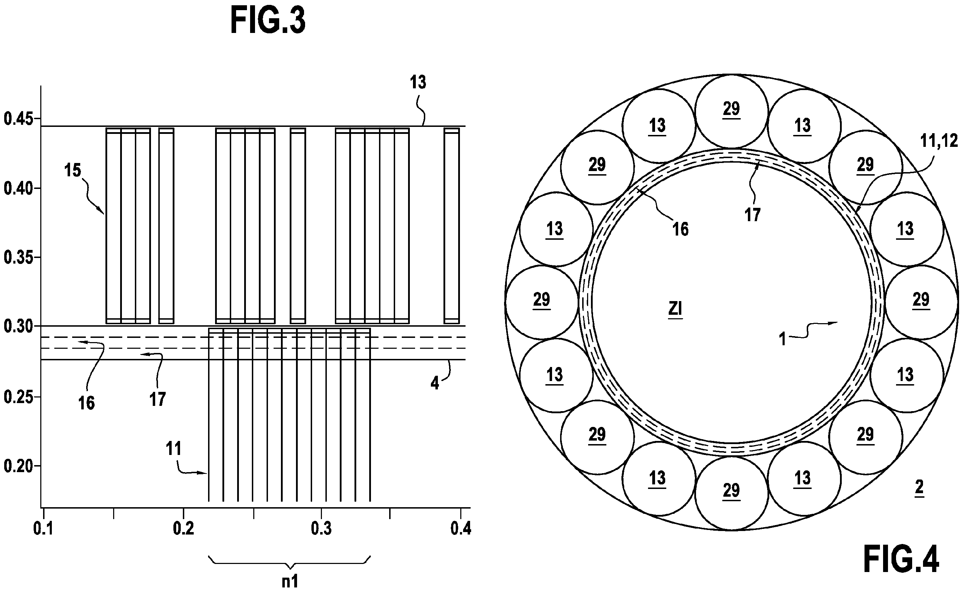

La figure 4 montre un exemple de répartition de tubes 13 autour des bobines 11 et 12.

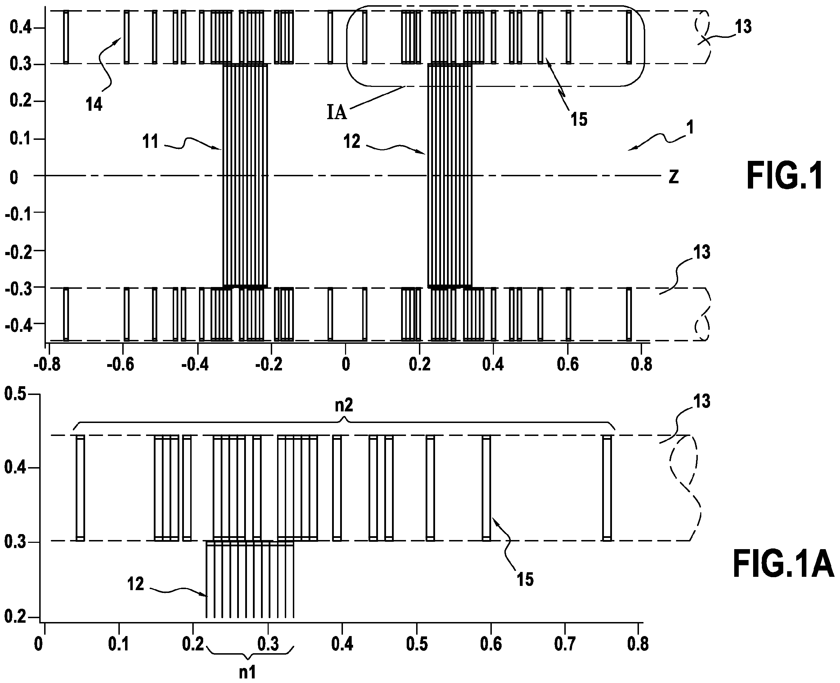

Les figures 1, 1A et 3 montrent un premier exemple d'association de bobines 11, 12 de gradient z d'axe Oz avec des couples de bobines 14, 15 placées dans des tubes 13 d'axe parallèle à l'axe Oz et disposés en couronne autour des bobines 11, 12. Ce premier exemple de réalisation permet d'annuler la composante $Z_3$ dans un développement en harmoniques sphériques réguliers (DHS). Les bobines 11, 12 peuvent par exemple comprendre un nombre n1 de 11 spires groupées juxtaposées selon l'axe Oz.

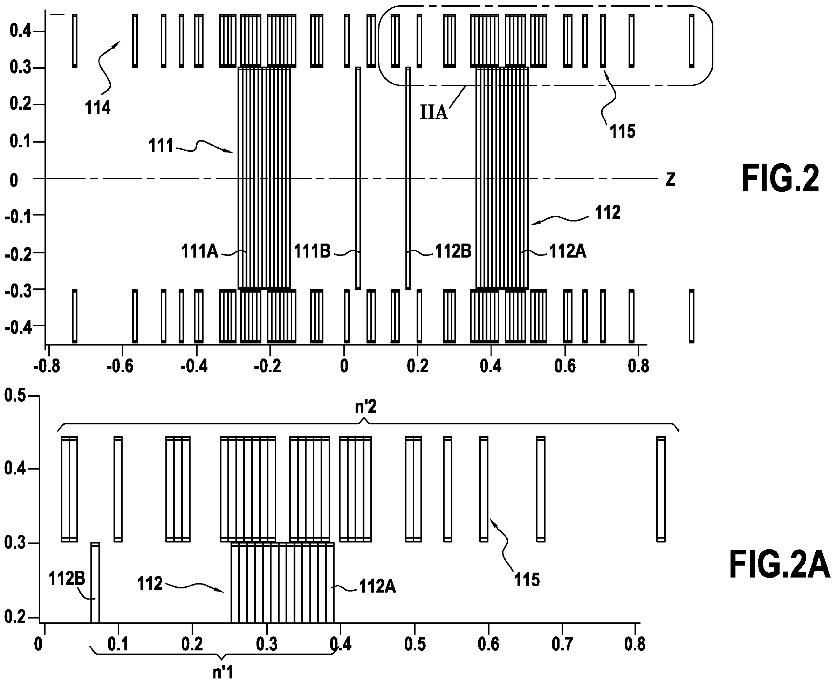

Les figures 2 et 2A montrent un deuxième exemple d'association de bobines 111, 112 de gradient z d'axe Oz avec des couples de bobines 114, 115 placées dans des tubes 13 d'axe parallèle à l'axe Oz et disposés en couronne autour des bobines 111, 112. Ce deuxième exemple de réalisation permet d'annuler les composantes $Z_3$ et $Z_5$ dans un développement en harmoniques sphériques réguliers (DHS). Dans ce cas, les bobines 111 et 112 comprennent chacune un nombre n'1 de spires avec par exemple un premier groupe 111A, 112A de 13 spires groupées juxtaposées selon l'axe Oz et une spire supplémentaire isolée 111B, 112B décalée selon l'axe Oz. Le nombre n'2 et la répartition des spires des bobines 114 et 115 selon l'axe Oz sont également différents du nombre n2 et de la répartition des spires des bobines 14 et 15 selon l'axe Oz. Le calcul en DHS est en effet opéré sur l'ensemble des bobines 11, 12, 14 et 15 pour annuler la composante $Z_3$ ou sur l'ensemble des bobines 111, 112, 114 et 115 pour annuler les composantes $Z_3$ et $Z_5$.

L'ensemble constitué des paires de bobines 11, 12 et 14, 15 ou celui constitué des paires de bobines 111, 112 et 114, 115 constituent un système de gradients hybrides selon z.

Le système 8 de génération de gradients comprend également des systèmes de gradients hybrides selon x et y.

Ainsi, le système 8 de génération de gradients comprend en troisième lieu un ensemble de cinquième, sixième, septième et huitième bobines de gradient x ayant une configuration en forme de selle de cheval avec chacun un nombre n3 de spires, les cinquième, sixième, septième et huitième bobines 21, 22, 23, 24 de gradient x étant disposées au voisinage des première et deuxième bobines solénoïdales 11, 12 de gradient z, à des positions symétriques radialement et longitudinalement par rapport à l'axe Oz pour produire une première composante de gradient de champ x dans une première direction radiale x de la machine perpendiculaire à l'axe Oz.

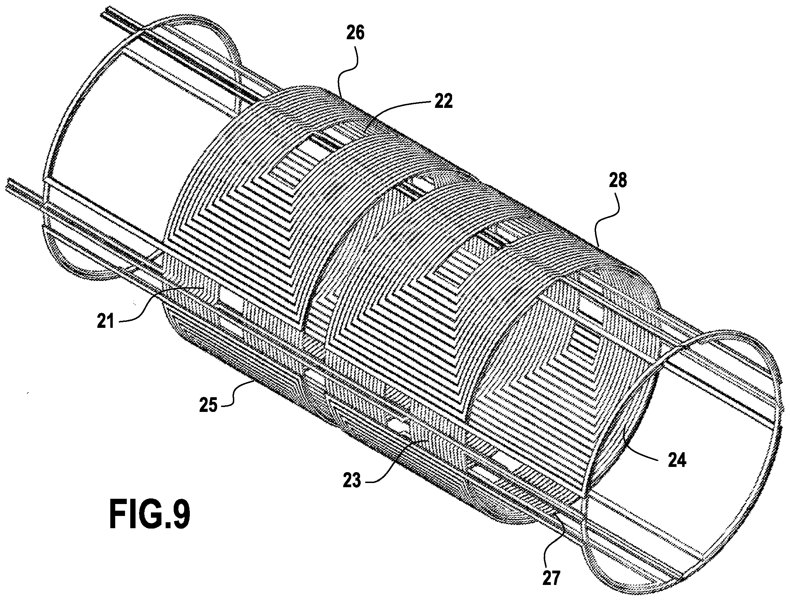

Pour la réalisation des systèmes de gradients hybrides selon x et y, le système 8 de génération de gradients comprend en quatrième lieu un ensemble de neuvième, dixième, onzième et douzième bobines 25, 26, 27, 28 de gradient y ayant une configuration en forme de selle de cheval avec chacune un nombre n4 de spires, les neuvième, dixième, onzième et douzième bobines 25, 26, 27, 28 de gradient y étant disposées au voisinage des première et deuxième bobines solénoïdales 11, 12 de gradient z, à des positions symétriques radialement et longitudinalement par rapport à l'axe Oz, en superposition respectivement aux cinquième, sixième, septième et huitième bobines 21, 22, 23, 24 de gradient x mais décalées de 90° par rapport à celles-ci pour produire une première composante de gradient de champ y dans une deuxième direction radiale y de la machine également perpendiculaire à l'axe Oz, la première direction x étant perpendiculaire à la deuxième direction y. La figure 9 montre un exemple possible de mise en oeuvre des bobines 21 à 24 et 25 à 28 pour la création d'une première composante de gradient x et y.

Enfin, pour la réalisation des systèmes de gradients hybrides selon x et y, le système 8 de génération de gradients comprend en cinquième lieu un ensemble de N2 deuxièmes tubes 29 non jointifs identiques d'axes parallèles à l'axe Oz et situés dans le sous-espace annulaire cylindrique 9 situé à l'intérieur du premier espace annulaire cylindrique 1 à l'extérieur des première et deuxième bobines 11, 12 de gradient z, en étant intercalés entre les premiers tubes 13, chacun des N2 deuxièmes tubes 29 comprenant des treizième et quatorzième bobines solénoïdales 31, 32 de gradient x et y symétriques par rapport à un plan xOy perpendiculaire à l'axe Oz, comprenant chacune une même pluralité n5 de spires identiques de diamètre inférieur au diamètre interne du tube correspondant 29 et réparties dans des positions prédéterminées selon l'axe de ce tube 29, les spires de la quatorzième bobine 32 disposée en regard de la deuxième bobine 12 étant parcourues par un courant de sens opposé à celui parcourant les spires de la deuxième bobine 12 et à celui parcourant les spires de la treizième bobine 31 elle-même disposée en regard de la première bobine 11 pour produire une deuxième composante à la fois de gradient de champ x et de gradient de champ y.

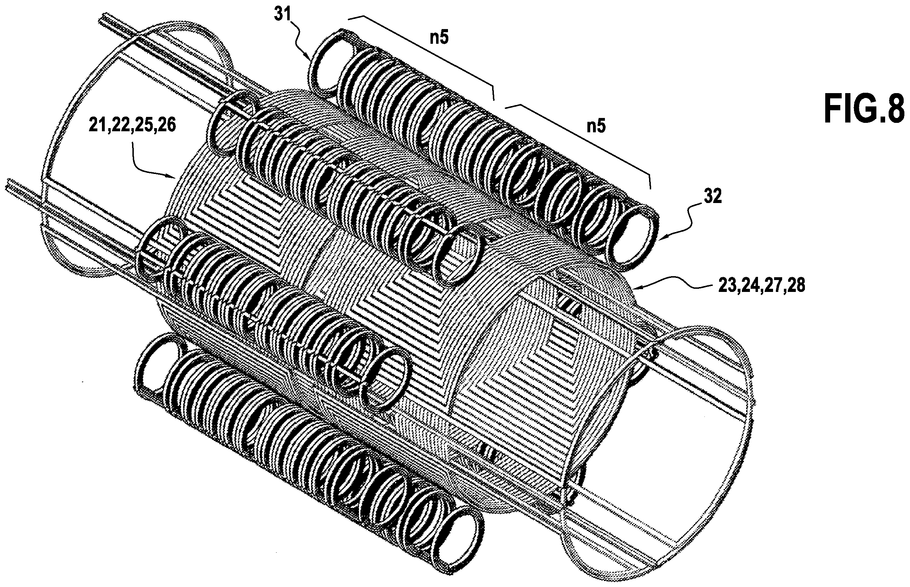

La figure 8 montre un exemple possible de mise en oeuvre à la fois des bobines 21 à 24 et 25 à 28 et d'une pluralité de paires de bobines 31, 32 réparties en couronne autour des bobines 21 à 24 et 25 à 28 pour la création de gradients hybrides x et y.

On donnera ci-dessous certains éléments de calcul permettant de déterminer les caractéristiques des différentes bobines constituant le système 8 de génération de gradients hybrides.

Pour le calcul, on prend en considération des éléments de base constitués par des arcs de spires circulaires (ou des spires complètes) d'axe Oz et des spires circulaires d'axe O'z' parallèle à Oz .

On peut établir à partir des équations fondamentales de l'électromagnétisme les expressions analytiques des composantes du champ et du potentiel vecteur magnétiques générés par de tels éléments en tout point de l'espace ainsi que les coefficients $Z_n$, $X_n^m$ et $Y_n^m$ du développement en harmoniques sphériques solides réguliers (DHS) de la composante Bz du champ magnétique qu'ils créent dans la région d'intérêt ZI au voisinage du point (ROI) suivant l'expression :

$$B_z = Z_0 + \sum_{n=1}^{\infty} r^n \left[ Z_n P_n \left( \cos \vartheta \right) + \sum_{m=1}^{n} \left( X_n^m \cos m\varphi + Y_n^m \sin m\varphi \right) P_n^m \left( \cos \vartheta \right) \right]$$

On donne ci-après quelques exemples de ces expressions.

1.1 Composantes du potentiel vecteur et du champ d'une spire en tout point

Soit une spire circulaire d'axe Oz, de rayon $a$, centrée en un point de cote $b$ et parcourue par un courant d'intensité I mesuré algébriquement autour de Oz. En un point de coordonnées cylindriques ($\rho, \varphi, z$), les seules composantes non nulles du potentiel vecteur et du champ ont pour expressions :

$$A_\varphi = \frac{\mu_0 I}{2\pi} \frac{r_1}{\rho} \left[ \left( 1 - \frac{k^2}{2} \right) K(k) - E(k) \right]$$

$$B_\rho = \frac{\mu_0 I}{2\pi} \frac{b-z}{\rho r_1} \left[ K(k) - \frac{a^2 + \rho^2 + \left( b - z \right)^2}{r_2^2} E(k) \right]$$

$$B_z = \frac{\mu_0 I}{2\pi} \frac{1}{r_1} \left[ K(k) + \frac{a^2 - \rho^2 - \left( b - z \right)^2}{r_2^2} E(k) \right]$$

$K(k)$ et $E(k)$ sont respectivement les intégrales elliptiques complètes de première espèce et de deuxième espèce, avec les notations suivantes :

$$k = \frac{2\sqrt{a\rho}}{r_1}$$

$$r_1 = \sqrt{\left( a + \rho \right)^2 + b^2}$$

$$r_2 = \sqrt{(a - \rho_0)^2 + b^2}$$

Pour un arc de spire, il n'y a plus symétrie de révolution et toutes les composantes existent avec des expressions un peu plus compliquées qui font intervenir des intégrales elliptiques incomplètes.

1.2 DHS d'un arc de spire

Soit un arc de spire d'axe Oz , de rayon $a$ et de cote $b$, parcouru par un courant d'intensité I entre les angles $\psi_1$ et $\psi_2$, mesurés algébriquement autour de Oz.

En posant $c = \sqrt{a^2 + b^2}$ et $\cos\alpha = \dfrac{b}{c}, 0 \le \alpha \le \pi$ on obtient le résultat suivant :

$$B_z = \frac{\mu_0 I}{2c} \frac{(\psi_2 - \psi_1)}{2\pi} \sum_{n=0}^{\infty} \left(\frac{r}{c}\right)^n \sin\alpha P_{n+1}^1(\cos\alpha) P_n(\cos\vartheta)$$

$$+ \frac{\mu_0 I}{c} \frac{1}{\pi} \sum_{n=1}^{\infty} \left(\frac{r}{c}\right)^n \sum_{m=1}^{n} \left\{ \begin{array}{l} \dfrac{(n-m)!}{(n+m)!} \left[ \dfrac{1}{m} \sin\alpha P_{n+1}^{m+1}(\cos\alpha) - P_n^m(\cos\alpha) \right] \\[2mm] \times \sin m \dfrac{\psi_2 - \psi_1}{2} \cos m \left( \varphi - \dfrac{\psi_1 + \psi_2}{2} \right) \end{array} \right\} P_n^m(\cos\vartheta)$$

Pour une spire complète $\psi_2 - \psi_1 = 2\pi$, on retrouve le résultat élémentaire bien connu :

$$B_z = \frac{\mu_0 I}{2c} \sum_{n=0}^{\infty} \left(\frac{r}{c}\right)^n \sin\alpha P_{n+1}^1(\cos\alpha) P_n(\cos\vartheta)$$

1.3 DHS d'une spire d'axe décalé

Soit une spire circulaire d'axe O'z', de rayon $a$, de cote $b$, parcourue par un courant d'intensité I. Les coordonnées cylindriques dans le référentiel Oxyz du centre $\Omega$ de la spire sont notées $(\rho_0, \varphi_0, b)$ et la trace O' de O'z' sur le plan xOy a pour coordonnées cylindriques $(\rho_0, \varphi_0, 0)$. Les expressions analytiques des coefficients du DHS font intervenir des intégrales elliptiques complètes de première espèce, $K(k)$, et de deuxième espèce, $E(k)$. Elles deviennent de plus en plus encombrantes quand le degré n et l'ordre m augmentent, mais elles se manipulent très bien avec un logiciel de calcul formel comme par exemple celui connu sous la dénomination Maple. On trouvera ci-après leurs expressions pour n=m=1 :

$$Z_1 = \frac{\mu_0 I}{2\pi} \frac{b}{r_1^3 r_2^2} \left[ \left(\rho_0^2 - a^2 + b^2\right) K(k) - \frac{\left(\rho_0^2 - a^2 + b^2\right)^2 + 4a^2\left(2\rho_0^2 - 2a^2 - b^2\right)}{r_2^2} E(k) \right]$$

$$\begin{bmatrix} X_1^1 \\ Y_1^1 \end{bmatrix} = \frac{\mu_0 I}{2\pi} \frac{1}{\rho_0 r_1^3 r_2^2} \left\{ \frac{\left[\left(\rho_0^2 - a^2\right)^2 + b^2\left(\rho_0^2 + a^2\right)\right] K(k)}{-\dfrac{\left(\rho_0^2 - a^2\right)^2\left(\rho_0^2 + a^2 + 2b^2\right) + b^4\left(\rho_0^2 + a^2\right) - 8\rho_0^2 a^2 b^2}{r_2^2} E(k)} \right\} \begin{Bmatrix} \cos \\ \sin \end{Bmatrix}$$

$$k = \frac{2\sqrt{a\rho_0}}{r_1}$$

$$r_1 = \sqrt{\left(a + \rho_0\right)^2 + b^2}$$

$$r_2 = \sqrt{\left(a - \rho_0\right)^2 + b^2}$$

Le système de gradients 8 doit s'insérer dans l'ouverture circulaire libre (dont le diamètre peut être typiquement de 900 mm) de l'aimant principal situé dans l'espace annulaire cylindrique extérieur 2 et laisser une ouverture circulaire libre (dont le diamètre peut être typiquement d'au moins 550 mm) pour le tunnel 4, qui soit suffisante pour l'insertion du patient et l'installation des antennes 3.

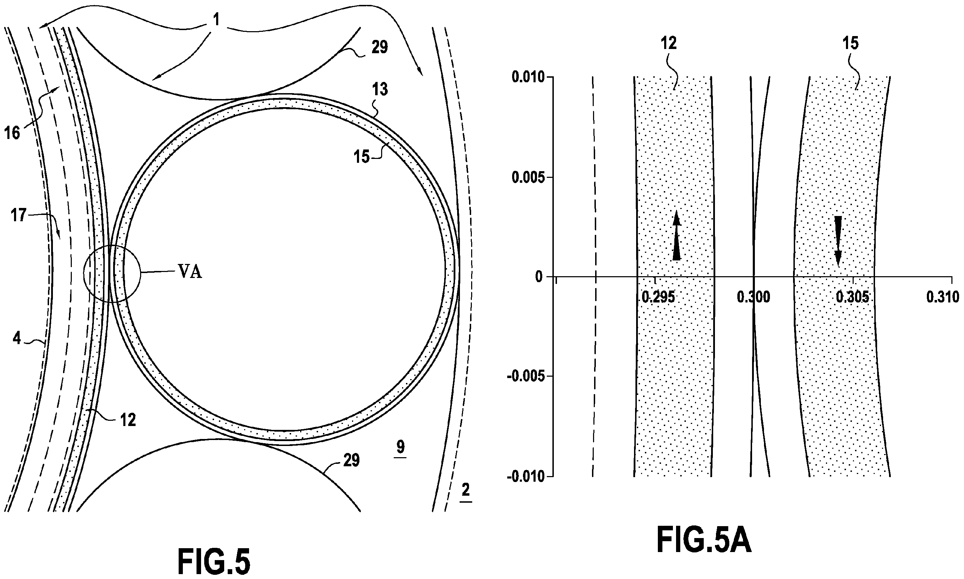

Il faut une certaine épaisseur radiale pour les couches de gradients classiques comprenant deux couches 16, 17 de bobines 21 à 24 et 25 à 28 en forme de selle de cheval pour les gradients x et y et une couche de bobines 11, 12 (ou 111, 112) de gradient z, à l'intérieur de la couronne de tubes 13 et 29 (voir les figures 4, 5 et 7). Dans cette solution privilégiée avec trois couches classiques 12 et 13, 16 et 17 (pour le gradient z et les gradients x, y) situées à l'intérieur de l'espace annulaire occupé par les tubes 13, 29, chaque couche 12 et 13, 16 et 17 occupe radialement 8 mm environ.

Ces considérations permettent de déterminer le nombre et le diamètre des tubes 13, 29 qui occuperont le maximum de l'espace disponible. Selon un exemple préférentiel, ceci conduit à un nombre privilégié de 16 tubes 13 ou 29, dont huit tubes référencés 13 (un sur deux) seront consacrés au gradient z et les huit autres tubes référencés 29 seront consacrés aux gradients x et y par superposition des courants correspondants dans les mêmes bobinages 31, 32.

Il est à remarquer que suivant la place disponible, on peut envisager d'autres combinaisons et donc des nombres différents pour les N1 tubes 13 et les N2 tubes 29, le nombre total N1 + N2 de tubes 13, 29 augmentant si l'on diminue l'épaisseur radiale totale du générateur de gradient 8. On peut ainsi envisager par exemple un nombre total de tubes N1 + N2 égal à 12 ou 24 au lieu de 16.

Contrairement à ce qui serait possible pour des dispositifs de gradients en tubes seuls, c'est-à-dire pour un générateur de gradients n'incluant ni les bobines 11, 12 (ou 111, 112) produisant une première composante de gradient z ni les bobines 21 à 24 et 25 à 28 en selles de cheval produisant une première composante de gradients x et y, il n'est pas possible d'obtenir à la fois la linéarité et le blindage (c'est-à-dire une réduction des courants induits) tout en faisant « cohabiter » les bobinages 14, 15 ou 114, 115 pour le gradient z d'une part, et les bobinages 31, 32 pour les gradients x et y d'autre part, dans les mêmes tubes, d'où la séparation en deux familles de tubes 13 et 29 respectivement. Comme on peut le voir sur la figure 6, les bobinages 31 et 32 peuvent être plus courts que les bobinages 14 et 15 ou 114 et 115 et par suite, les tubes 13 incorporant les bobinages 31 et 32 peuvent être plus courts que les tubes 29 incorporant les bobinages 14 et 15 ou 114 et 115.

Un système 8 de génération de gradients présente des contraintes de refroidissement et d'alimentation électrique.

Ainsi, les amplificateurs et leurs composants électroniques disponibles, incorporés dans le dispositif d'alimentation 6 de la figure 19, conditionnent l'intensité nominale dans les conducteurs (typiquement en cuivre) du système 8 ainsi que la tension maximum admissible lors de la génération des impulsions de courant correspondant à la séquence d'imagerie choisie.

Cette intensité nominale est typiquement de plusieurs centaines d'ampères (par exemple 625 A dans les exemples donnés) et elle détermine la section minimale des conducteurs compatible avec les modalités d'évacuation de la chaleur par circulation d'un fluide caloporteur (eau, huile, air...). La section des conducteurs peut-être différente pour les bobinages des tubes ou pour les bobinages classiques mais elle sera typiquement de quelques dizaines de mm², par exemple un méplat de cuivre de 10×4 *mm²* dans les exemples donnés.

Dans les tubes 13 ou 29, les bobinages sont constitués de spires circulaires à des positions déterminées sur une couche (bobines 14, 15 ou 114, 115 de gradient z) ou sur plusieurs couches, par exemple deux couches (bobines 31, 32 de gradients x et y). La détermination peut être effectuée par exemple conformément à l'enseignement du document WO 2005/029110 A2.

Pour les couches « classiques », les bobinages 11, 12 ou 111, 112 du gradient z sont des spires circulaires d'axe Oz à des positions déterminées sur une seule couche alors que les bobinages 21 à 24 et 25 à 28 du gradient x ou du gradient y sont des selles de cheval rectangulaires de positions et dimensions déterminées, par exemple suivant les documents de brevet EP 0 221 810 A1 ou WO 8903031 A, ou des selles de cheval de formes plus complexes par exemple suivant le document de brevet US 4 617 516 A ou EP 0 140 259 B1.

Selon un aspect important de la présente invention, on détermine les caractéristiques de l'ensemble des bobines solénoïdales à l'aide du développement en harmoniques sphériques solides réguliers de la composante Bz du champ magnétique créé dans la zone d'intérêt ZI par chaque spire ou arc de spire d'une bobine solénoïdale, en fonction de la puissance disponible de l'alimentation électrique des bobines, du diamètre externe du tunnel 4 définissant la zone d'intérêt ZI et du diamètre interne du deuxième espace annulaire cylindrique 2 extérieur comprenant le dispositif d'aimant supraconducteur. Chaque dispositif de gradient hybride, par exemple composé des éléments 11 à 15 pour le gradient z et des éléments 21 à 24, 25 à 28, 29, 31, 32 pour les gradients x et y, qui comprend d'une part un dispositif « classique » et d'autre part un dispositif « en tubes » est déterminé globalement à partir de DHS comme indiqué plus haut.

On donnera ci-dessous différentes considérations concernant l'obtention de la configuration optimale pour le gradient z.

Dans chacun des N2 tubes 13 dédiés au gradient z, on dispose $2 \times n_2$ spires de plus grand diamètre possible (bobines 14 et 15), dont les positions axiales sont des inconnues à déterminer. Les spires sont géométriquement symétriques par rapport au plan médian xOy et parcourues par des courants de sens opposés.

On dispose également $2 \times n_1$ spires du diamètre correspondant à la couche classique z (bobines 11, 12) et dont les positions axiales sont également des inconnues à déterminer. Ces spires obéissent aux mêmes propriétés de symétrie géométrique et d'antisymétrie pour les courants que celles des bobines 14, 15 incorporées dans des tubes 13.

Enfin, les courants dans les spires des bobines 14, 15 des tubes 13 et dans les spires classiques 11, 12 du même côté du plan xOy sont de sens opposés, produisant ainsi des champs de gradient z qui s'ajoutent dans la ROI alors que leurs composantes azimutales du potentiel vecteur à l'extérieur se compensent.

Toutes ces spires étant parcourues par la même intensité nominale en valeur absolue et avec les sens précisés ci-dessus, il faut déterminer les nombres entiers $n_1$ et $n_2$ ainsi que les $n_1 + n_2$ cotes axiales des spires pour produire un gradient z ayant une intensité donnée (par exemple 70 mT/m dans les exemples qui seront donnés plus loin) tout en possédant la qualité de linéarité et le niveau de blindage souhaités.

Compte tenu des symétries imposées pour la géométrie et les courants, les seuls termes non nuls du DHS dans le ROI sont les termes axiaux de degré impair, soit $Z_1$ qui donne l'intensité du gradient et $Z_3, Z_5, Z_7,...$ qui caractériseront la linéarité.

On remarquera que, outre les termes axiaux, les N2 tubes génèreront des coefficients $X_n^m$ et $Y_n^m$ avec $n{\geq}N_2$ et donc négligeables si N2 n'est pas trop petit, comme expliqué dans les brevets relatifs aux gradients en tubes (voir par exemple le document WO 2005/029110 A2 ou le document WO 2007/048983 A2).

Les formules indiquées plus haut fournissent les expressions analytiques de ces $Z_{2p+1}$ en fonction des $n_1+n_2$ cotes inconnues, dont celle de $Z_1$, c'est à dire le gradient. Une première étape pour obtenir une bonne linéarité est d'imposer la condition $Z_3=0$ ce qui est pratiquement suffisant (voir les figures 1 et 1A) et si l'on veut faire encore mieux on imposera $Z_3=Z_5=0$ (voir les figures 2 et 2A).

Par ailleurs, les équations de Maxwell indiquent que l'origine des courants induits dans les enveloppes conductrices extérieures au système 8 de gradients est la variation temporelle de la composante azimutale du potentiel vecteur. Les formules mentionnées plus haut en fournissent également les expressions analytiques et pour réaliser le blindage, on imposera que le module de cette composante ne dépasse pas une valeur maximum fixée à un certain nombre de points de la région occupée par les enveloppes conductrices. Comme on a affaire à des fonctions continues et que le potentiel vecteur décroît avec la distance à ses sources, on imposera cette condition sur le module à un ensemble de points situés sur la génératrice d'un cylindre circulaire (par exemple 50 points régulièrement répartis entre la cote 0 et la cote 2m sur un cylindre de rayon 0,5m si le diamètre extérieur du système de gradients est 0,45m).

On a donc un problème d'optimisation non linéaire dont la fonction objectif à maximiser est $Z_1$ avec des conditions non linéaires (égalités pour la linéarité, inégalités pour le blindage). Dès lors que l'on dispose d'expressions analytiques pour la fonction objectif et pour les contraintes, on peut utiliser les sous-programmes généraux des librairies mathématiques comme par exemple les sous-programmes E04UCF ou E04WDF de la librairie NAG qui est accessible librement en ligne avec les liens ci-dessous, http://www.nag.co.uk/numeric/fl/nagdoc_fl22/pdf/E04/e04ucf.pdf http://www.nag.co.uk/numeric/fl/nagdoc_fl22/pdf/E04/e04wdf.pdf

Les valeurs de $n_1$ et de $n_2$ doivent être données a priori et les valeurs finales résultent d'une une succession d'essais de façon itérative.

Une fois les cotes obtenues, la résistance électrique et l'inductance de l'ensemble peuvent être calculées suivant les méthodes classiques de l'électromagnétisme.

On donnera maintenant ci-dessous différentes considérations concernant l'obtention de la configuration optimale pour les gradients x ou y.

La démarche est identique à celle décrite supra pour le gradient z quant à son principe. La partie classique nécessite une couche 16 pour le gradient x et une couche séparée 17 pour le gradient y, chaque couche 16, 17 étant constituée de quatre bobinages en selles de cheval 21 à 24, 25 à 28 respectivement par exemple suivant les documents de brevet susmentionnés (brevet EP 0 221 810 A1 ou WO 8903031 A, brevet US 4 617 516 A ou EP 0 140 259 B1).

La partie en tubes 29 utilise les mêmes bobinages 31 et 32 pour générer à la fois le gradient x et le gradient y par superposition des courants nécessaires à chacun d'eux. La partie du courant qui génère le gradient x est proportionnelle à $\cos \varphi_0$ où $\varphi_0$ est l'azimut du tube alimenté alors que la partie du courant qui génère le gradient y est proportionnelle à $\sin \varphi_0$.

Le gradient x total est égal au coefficient $X_1^1$ du DHS alors que le gradient y total est égal à $Y_1^1$. La linéarité de la composante $B_z$ du champ créé par chacun des gradients est obtenue en imposant les conditions $X_3^1 = X_3^3 = 0$ pour le gradient x ainsi que $X_5^1$ 5 si l'on souhaite une linéarité meilleure, et les conditions similaires avec $X \to Y$ pour le gradient y.

Alors que pour le gradient z la source excitatrice des courants induits est la composante azimutale du potentiel vecteur, on montre que dans le cas des gradients x ou y la source excitatrice principale est la composante de Fourier en $\cos \varphi$ ou en $\sin \varphi$ respectivement de la composante radiale $B_\rho$ du champ_magnétique généré au niveau des enveloppes conductrices. C'est donc sur ces composantes de Fourier, dont on sait donner les expressions analytiques à partir des formules rappelées plus haut, que porteront les contraintes d'encadrement conduisant au blindage souhaité, suivant les mêmes modalités que celles imposées à la composante azimutale du potentiel vecteur pour le gradient z.

On notera que les sens des courants dans les selles de cheval 21 à 24, 25 à 28 et dans les tubes 29 sont imposés a priori pour que leurs contributions aux gradients s'ajoutent en même temps que leurs contributions à l'excitation des courants induits dans les enveloppes extérieures se retranchent, ce qui constitue l'une des caractéristiques essentielles de l'invention.

Le problème d'optimisation non linéaire est similaire à celui décrit plus haut pour le gradient z, la fonction objectif à maximiser étant maintenant $X_1^1$ ou $Y_1^1$ avec les conditions non linéaires (égalités pour la linéarité, inégalités pour le blindage) explicitées ci-dessus.

Les essais conduisant au nombre $n_3$ ou $n_4$ de spires de chaque selle de cheval 21, 22, 23, 24, 25, 26, 27 ou 28 et au nombre $n_5$ de spires des bobines 31, 32 de chacun des tubes 29 montrent que les bobinages des tubes 29 de gradients x et y doivent être plus rapprochés du plan médian que ceux des tubes 13 de gradient z et qu'il faut donc les disposer sur plusieurs couches, par exemple deux ou trois.

Il faut également insister sur le fait que le choix de la technique des brevets EP 0 221 810 A1 ou WO 8903031 A pour les selles de cheval composées exclusivement, d'une part, d'arcs de spire circulaire dont on connait les expressions analytiques des composantes du champ et du DHS et, d'autre part, de portions parallèles à Oz qui ne contribuent pas à la composante $B_z$ du champ dans le ROI et dont on connait également les expressions analytiques de leurs contributions à la composante radiale $B_\rho$ à l'extérieur, est à préférer à d'autres techniques pour lesquelles on ne connait pas ces expressions analytiques, ce qui constitue un handicap sérieux pour le processus d'optimisation.

Comme pour le gradient z, ce processus permet de déterminer $n_3$, $n_4$ et les cotes correspondantes des spires des selles de cheval et des tubes dont les figures montrent des exemples. Il reste alors à calculer, par les méthodes classiques, la résistance électrique et l'inductance de chacun des ensembles x et y.

La présente invention vise à réaliser un générateur 8 de gradients qui malgré des conditions de mise en oeuvre sévères, permette un fonctionnement amélioré.

L'invention est adaptée à des valeurs nominales de gradients de l'ordre de 70 mT/m obtenues en utilisant des amplificateurs qui, à titre d'exemple, peuvent être réalisés selon une technologie IGBT et peuvent présenter un fonctionnement avec une tension de 2 kV, une intensité de 625 A et une puissance moyenne de 70 kW.

Les bobinages doivent être réalisés de façon à présenter une résistance électrique minimale et également une inductance minimale, tout en étant installés dans un espace cylindrique circulaire annulaire réduit et en présentant une haute qualité géométrique pour produire une composante de champ magnétique Bz la plus linéaire possible. Les bobines de compensation servant de blindage pour limiter les courants induits dans les enveloppes conductrices extérieures doivent pouvoir limiter le bruit et les vibrations sans affaiblir les gradients de champ magnétique créés par les bobines de base.

Dans le système 8 de génération de gradients hybrides selon l'invention, qui met en oeuvre des bobines de base constituées par des dispositifs de gradient « classiques » pour la génération des gradients de champ magnétique utiles et des bobines de compensation (blindage) constituées par des bobines « en tubes », on résout un problème d'optimisation non linéaire avec des limites et des contraintes non linéaires par une méthode analytique et un développement en harmoniques sphériques solides réguliers de la composante du champ magnétique créé dans la région d'intérêt par des éléments de bobine (spire ou arc de spire), pour déterminer les moyens de création de gradients linéaires, et on utilise également une méthode analytique pour déterminer les caractéristiques des éléments de blindage et définir en un point de coordonnées cylindriques $(\rho,\varphi,z)$ les composantes non nulles du potentiel vecteur et du champ par des séries de Fourier en $\varphi$, des séries de Fourier-Bessel en $\rho$ et une transformation de Fourier en z.

Le système 8 de génération de gradients hybrides comprend pour la génération des gradients de base au moins deux nappes superficielles de courant par direction de gradient sur des cylindres circulaires d'axe Oz.

Chaque nappe superficielle comprenant les bobines cylindriques 11, 12 ou 111, 112 pour le gradient z ou les bobines en forme de selle de cheval 21 à 24 et 25 à 28 pour les gradients x et y, peut être formée de conducteurs filiformes de section circulaire ou rectangulaire ou le cas échéant de tubes cylindriques découpés.

Le système 8 de génération de gradients hybrides comprend pour la génération des gradients de compensation (blindage) des bobinages solénoïdaux dont les axes sont des génératrices équidistantes d'un cylindre d'axe Oz. On a ainsi des bobinages 14, 15 ou 114, 115 pour le gradient z et des bobinages 31, 32 pour les gradients x et y.

L'intensité nominale est imposée par l'amplificateur et détermine le choix de la section des canaux conducteurs compte tenu de la technique de refroidissement. Par exemple pour une intensité nominale de 625 A on peut choisir une section de conducteur de l'ordre de 40 mm$^2$.

Comme on l'a déjà indiqué, la mise en oeuvre de dispositifs de génération de gradients « en tubes » à la fois comme gradients sources et comme blindage, comme proposé par exemple dans le document WO 2007/048983 A2, présente une certaine efficacité, mais conduit à un encombrement trop important dans le sens radial, qui limite les applications pratiques.

Par ailleurs, la mise en oeuvre d'un blindage à l'aide de dispositifs de gradient « classiques » (bobines en selle de cheval ou bobines solénoïdales centrées sur l'axe Oz) crée des courants induits qui affaiblissent les gradients sources créés par des dispositifs de gradient « classiques » ou même du type « en tubes » disposés en couronne. En effet, la couche secondaire extérieure nécessaire au blindage diminue le gradient généré par la couche primaire intérieure et la valeur souhaitée du gradient ne peut être obtenue qu'en sacrifiant la linéarité.

Au contraire, dans le cas d'un système 8 de génération de gradients hybrides selon l'invention, on utilise pour la production des gradients sources des dispositifs de gradient classiques qui occupent peu d'espace dans le sens radial, et les dispositifs de gradient « en tubes » utilisés pour le blindage extérieur produisent des courants induits qui par nature, du fait de la conception des dispositifs de gradients « en tubes », renforcent les gradients sources. On dispose ainsi d'un système 8 de génération de gradients qui est à la fois compact et efficace permettant de conserver une excellente linéarité.

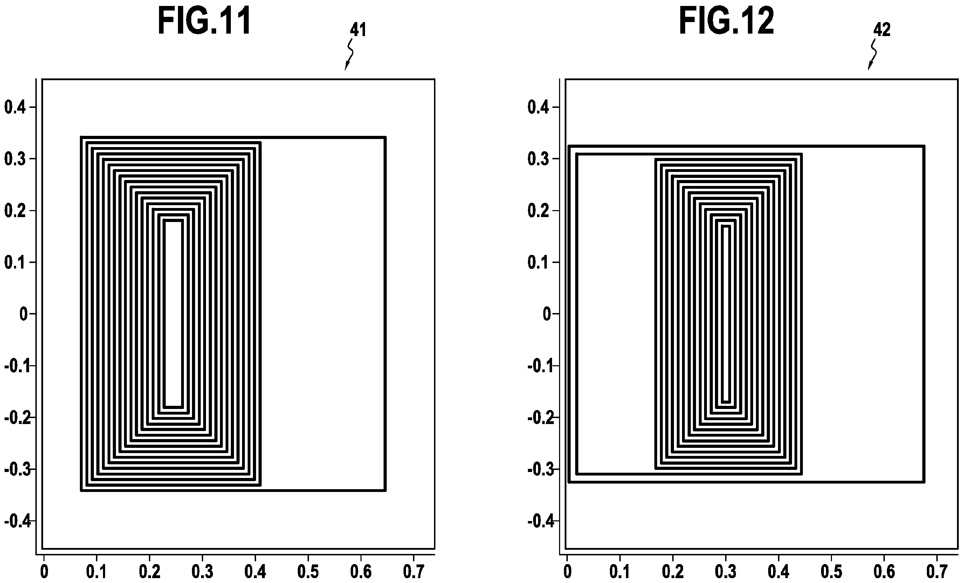

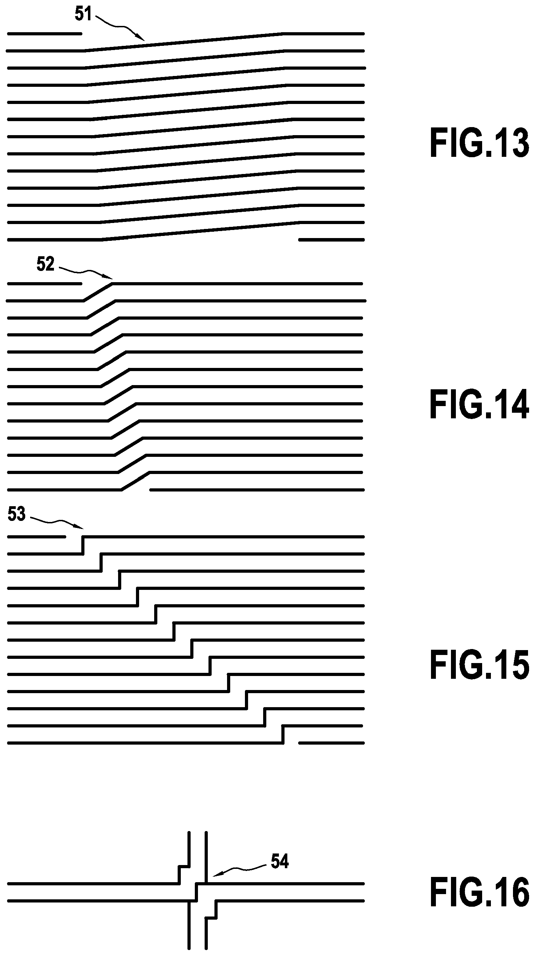

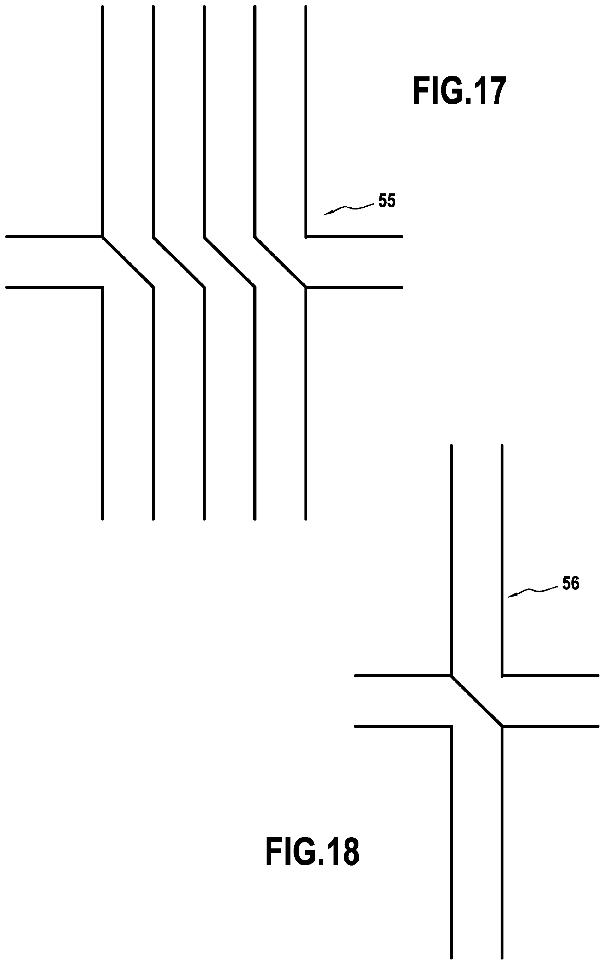

Les figures 11 et 12 montrent, dans des vues développées en plan, des exemples de réalisation de bobinages 41, 42 pouvant constituer les bobines 21 à 28 en forme de selle de cheval. Sur les figures 11 et 12, on a représenté des spires concentriques non raccordées, telles qu'elles peuvent se présenter dans des calculs intermédiaires lors de la détermination de ces bobines. En pratique, on réalise des transitions inter-spires 51 à 56 entre les différentes spires par exemple selon l'un des exemples donnés sur les figures 13 à 18.

Dans le cas de la figure 13, les transitions 51 sont étalées, le cas échéant sur toute la longueur dans une configuration proche d'une hélice.

Dans le cas des figures 14 et 15, on a des transitions 52 et 53 du type orthocyclique.

Les figures 16 à 18 montrent de façon agrandie des exemples de transitions inter-spires 54 à 56, dans lesquelles la connexion s'effectue sur la même génératrice, ce qui peut s'avérer avantageux d'un point de vue mécanique et pour la réalisation des supports. On peut noter que la réduction de la largeur du canal conducteur dans la transition peut être compensée par une surépaisseur du côté intérieur.

On donnera ci-dessous à titre d'exemple, les caractéristiques d'un dispositif de génération de gradient z hybride selon l'invention mettant en oeuvre des bobines 11, 12 et 14, 15 des figures 1 et 1A, alimentées par un amplificateur à technologie IGBT de 2 kV crête et 625 A en continu:

Gradient z avec $Z_3 = 0$ : $G_z = 71,000$ mT/m
Linéarité : -0,54% @ 0,1 m
-2,60% @ 0,15 m
Potentiel vecteur qui génère les courants de Foucault vers l'extérieur : $A\varphi \approx 9$ µT.m @ 0,5 m

Résistance : R = 80 mΩ
Puissance : P = 31,328 kW
Inductance : L = 0,430 mH
Temps de commutation : Δ = 0,134 ms

On constate ici que pour une valeur nominale d'intensité du gradient $G_z$ un peu plus élevée qu'avec des dispositifs de l'art antérieur l'ensemble des autres valeurs sont plus réduites, ce qui dénote une linéarité améliorée, une limitation des courants induits, une résistance et une inductance réduites, un temps de commutation également réduit, pour un ensemble d'éléments qui occupent eux-mêmes un espace réduit, les bobines 11, 12 et 14, 15 pouvant par exemple être disposées dans un espace annulaire cylindrique de diamètre intérieur voisin de 60 cm et de diamètre extérieur voisin de 90 cm, comme on peut le voir sur les figures 1 et 1A. De la même façon, dans le mode de réalisation des figures 2 et 2A, les bobines 111, 112, 114 et 115 peuvent être disposées dans un espace annulaire cylindrique de diamètre intérieur voisin de 60 cm et de diamètre extérieur voisin de 90 cm.

Dans l'exemple donné ci-dessus qui correspond aux figures 1 et 1A, la contribution des bobines 11, 12 et 14, 15 au gradient z est respectivement la suivante :

Bobines 11 et 12 : 58,461 mT/m
8 paires de bobines 14 et 15 placées dans 8 tubes 13 : 12,539 mT/m

On voit que pour la production du gradient z total de 71 mT/m, si la part des bobines 11 et 12 est prépondérante, l'ensemble des paires de bobines 14, 15 contribue bien à renforcer ce gradient et non à l'affaiblir, bien que ces paires de bobines 14, 15 jouent un rôle de blindage réduisant les courants de Foucault induits vers les enveloppes extérieures.

L'invention concerne également une machine d'imagerie par résonance magnétique nucléaire à gradients améliorés, comprenant un tunnel 4 d'axe Oz et de section essentiellement circulaire définissant un volume d'intérêt ZI, un premier espace annulaire cylindrique 1 entourant le volume d'intérêt ZI et comprenant un système 8 de génération de gradients de champ magnétique tel que décrit plus haut pour créer un gradient de champ magnétique dans le volume d'intérêt ZI, un deuxième espace annulaire cylindrique 2 extérieur formant cryostat entourant le premier espace annulaire cylindrique 1 et comprenant un dispositif d'aimant supraconducteur pour générer une composante de champ magnétique homogène Bz selon l'axe Oz dans le volume d'intérêt ZI, un dispositif 3 d'antennes d'émission radiofréquence disposé à l'intérieur du tunnel 4 ou au voisinage de celui-ci dans le premier espace annulaire cylindrique 1 et des dispositifs 6 d'alimentation électrique du système 8 de génération de gradients et du dispositif 3 d'antennes (voir la figure 19).

L'invention a encore pour objet un procédé de réalisation d'un système de génération de gradients de champ magnétique disposé dans un premier espace annulaire cylindrique 1 autour d'un tunnel 4 d'axe Oz et de section essentiellement circulaire définissant un volume d'intérêt ZI dans une machine 7 d'imagerie par résonance magnétique nucléaire comprenant un deuxième espace annulaire cylindrique 2 extérieur formant cryostat entourant le premier espace annulaire cylindrique 1 et comprenant un dispositif d'aimant supraconducteur pour générer une composante de champ magnétique homogène Bz selon l'axe Oz dans le volume d'intérêt ZI, , pour créer un gradient de champ magnétique dans le volume d'intérêt ZI.

Ce procédé comprend les étapes suivantes :

- former à l'intérieur du premier espace annulaire cylindrique 1, des première et deuxième bobines solénoïdales 11, 12 de gradient z comprenant chacune une même pluralité n1 de spires identiques d'axe Oz et de diamètre inférieur au diamètre externe du premier espace annulaire cylindrique 1, les spires de la deuxième bobine 12 étant parcourues par un courant de sens opposé à celui parcourant les spires de la première bobine 11 pour produire une première composante de gradient de champ z dans une direction axiale z parallèle à l'axe Oz ;
- former un ensemble de N1 premiers tubes 13 non jointifs identiques d'axes parallèles à l'axe Oz et disposés dans un sous-espace annulaire cylindrique 9 situé à l'intérieur du premier espace annulaire cylindrique 1 à l'extérieur des première et deuxième bobines 11, 12 de gradient z, chacun des N1 premiers tubes 13 comprenant des troisième et quatrième bobines solénoïdales 14, 15 de gradient z symétriques par rapport à un plan xOy perpendiculaire à l'axe Oz, comprenant chacune une même pluralité n2 de spires identiques de diamètre inférieur au diamètre interne du tube correspondant 13 et réparties dans des positions prédéterminées selon l'axe de ce tube 13, les spires de la quatrième bobine 15 disposée en regard de la deuxième bobine 12 étant parcourues par un courant de sens opposé à celui parcourant les spires de la deuxième bobine 12 et à celui parcourant les spires de la troisième bobine 14 elle-même disposée en regard de la première bobine 11 pour produire une deuxième composante de gradient de champ z dans la direction axiale z parallèle à l'axe Oz ;
- former un ensemble de cinquième, sixième, septième et huitième bobines de gradient x ayant une configuration en forme de selle de cheval avec chacune un nombre n3 de spires, les cinquième, sixième, septième et huitième bobines 21, 22, 23, 24 de gradient x étant disposées au voisinage des première et deuxième bobines solénoïdales

11, 12 de gradient z, à des positions symétriques radialement et longitudinalement par rapport à l'axe Oz pour produire une première composante de gradient de champ x dans une première direction radiale x de la machine perpendiculaire à l'axe Oz ;

- former un ensemble de neuvième, dixième, onzième et douzième bobines 25, 26, 27, 28 de gradient y ayant une configuration en forme de selle de cheval avec chacun un nombre n4 de spires, les neuvième, dixième, onzième et douzième bobines 25, 26, 27, 28 de gradient y étant disposées au voisinage des première et deuxième bobines solénoïdales 11, 12 de gradient z, à des positions symétriques radialement et longitudinalement par rapport à l'axe Oz, en superposition respectivement aux cinquième, sixième, septième et huitième bobines 21, 22, 23, 24 de gradient x mais décalées de 90° par rapport à celles-ci pour produire une première composante de gradient de champ y dans une deuxième direction radiale y de la machine également perpendiculaire à l'axe Oz, la première direction x étant perpendiculaire à la deuxième direction y;

- former un ensemble de N2 deuxièmes tubes 29 non jointifs identiques d'axes parallèles à l'axe Oz et situés dans le sous-espace annulaire cylindrique 9 situé à l'intérieur du premier espace annulaire cylindrique 1 à l'extérieur des première et deuxième bobines 11, 12 de gradient z, en étant intercalés entre les premiers tubes 13, chacun des N2 deuxièmes tubes 29 comprenant des treizième et quatorzième bobines solénoïdales 31, 32 de gradient x et y symétriques par rapport à un plan xOy perpendiculaire à l'axe Oz, comprenant chacune une même pluralité n5 de spires identiques de diamètre inférieur au diamètre interne du tube correspondant 29 et réparties dans des positions prédéterminées selon l'axe de ce tube 29, les spires de la quatorzième bobine 32 disposée en regard de la deuxième bobine 12 étant parcourues par un courant de sens opposé à celui parcourant les spires de la deuxième bobine 12 et à celui parcourant les spires de la treizième bobine 31 elle-même disposée en regard de la première bobine 11 pour produire une deuxième composante à la fois de gradient de champ x et de gradient de champ y.

Selon ce procédé, on détermine les caractéristiques de l'ensemble des bobines solénoïdales à l'aide du développement en harmoniques sphériques solides réguliers de la composante Bz du champ magnétique créé dans la zone d'intérêt par chaque spire ou arc de spire d'une bobine solénoïdale, en fonction de la puissance disponible de l'alimentation électrique des bobines, du diamètre externe du tunnel 4 définissant la zone d'intérêt ZI et du diamètre interne du deuxième espace annulaire cylindrique 2 extérieur comprenant le dispositif d'aimant supraconducteur.

## Revendications

1.  Système de génération de gradients de champ magnétique, disposé dans un premier espace annulaire cylindrique (1) autour d'un tunnel (4) d'axe Oz et de section essentiellement circulaire définissant un volume d'intérêt (ZI) dans une machine (7) d'imagerie par résonance magnétique nucléaire, pour créer un gradient de champ magnétique dans ledit volume d'intérêt (ZI), ledit système comprenant, à l'intérieur du premier espace annulaire cylindrique (1), au moins des première et deuxième bobines (11, 12) solénoïdales de gradient z, d'axe Oz parcourues par des courants de sens opposés; un ensemble de N1 premiers tubes (13) non jointifs identiques de gradient z d'axes parallèles à l'axe Oz et disposés dans un sous-espace annulaire cylindrique (9) situé à l'intérieur dudit premier espace annulaire cylindrique (1) à l'extérieur desdites première et deuxième bobines (11, 12) de gradient z, chacun des N1 premiers tubes (13) comprenant au moins des troisième et quatrième bobines (14, 15) solénoïdales parcourues par des courants de sens oppposés ; au moins des cinquième à huitième bobines (21, 22, 23, 24) de gradient x en forme de selle de cheval et des neuvième à douzième bobines (25, 26, 27, 28) de gradient y en forme de selle de cheval disposées autour des première et deuxième bobines (11, 12) de gradient z; un ensemble de N2 deuxièmes tubes (29) non jointifs identiques de gradients x et y d'axes parallèles à l'axe Oz et situés dans ledit sous-espace annulaire cylindrique (9) à l'extérieur des première et deuxième bobines (11, 12) de gradient z, en étant intercalés entre les premiers tubes (13) de gradient z dans ledit sous-espace annulaire cylindrique (9), chacun des deuxièmes tubes (29) de gradient x et y comprenant au moins des treizième et quatorzième bobines (31, 32) solénoïdales parcourues par des courants de sens opposés, les directions x et y étant orthogonales entre elles et orthogonales à l'axe Oz, les première et deuxième bobines (11, 12) étant symétriques par rapport à un plan xOy perpendiculaire à l'axe Oz, les troisième et quatrième bobines (14, 15) étant symétriques par rapport à ce plan xOy, les cinquième à huitième bobines (21, 22, 23, 24) d'une part et les neuvième à douzième bobines (25, 26, 27, 28) d'autre part étant également symétriques par rapport à ce plan xOy et les treizième et quatorzième bobines (31, 32) étant également symétriques par rapport à ce plan xOy.

2.  Système de génération de gradients de champ magnétique selon la revendication 1, **caractérisé en ce que** chacune des première et deuxième bobines solénoïdales (11, 12) de gradient z comprend une même pluralité n1 de spires identiques d'axe Oz et de diamètre inférieur au diamètre externe du premier espace annulaire cylindrique (1), les spires de la deuxième bobine (12) étant parcourues par un courant de sens opposé à celui parcourant les spires de la première bobine (11) pour produire une première composante de gradient de champ z dans une direction axiale z parallèle à l'axe Oz ; **en ce que** chacune des troisième et quatrième bobines solénoïdales (14, 15) de gradient z comprend une même pluralité n2 de spires identiques de diamètre inférieur au diamètre interne du tube correspondant (13) et réparties dans des positions prédéterminées selon l'axe de ce tube (13), les spires de la quatrième bobine (15) disposée en regard de la deuxième bobine (12) étant parcourues par un courant de sens opposé à celui parcourant les spires de la deuxième bobine (12) et à celui parcourant les spires de la troisième bobine (14) elle-même disposée en regard de la première bobine (11) pour produire une deuxième composante de gradient de champ z dans ladite direction axiale z parallèle à l'axe Oz ; **en ce que** chacune des cinquième, sixième, septième et huitième bobines de gradient x comprend un nombre n3 de spires, les cinquième, sixième, septième et huitième bobines (21, 22, 23, 24) de gradient x étant disposées au voisinage des première et deuxième bobines solénoïdales (11, 12) de gradient z, à des positions symétriques radialement et longitudinalement par rapport à l'axe Oz pour produire une première composante de gradient de champ x dans une première direction radiale x de la machine perpendiculaire à l'axe Oz ; **en ce que** chacune des neuvième, dixième, onzième et douzième bobines (25, 26, 27, 28) de gradient y comprend un nombre n4 de spires, les neuvième, dixième, onzième et douzième bobines (25, 26, 27, 28) de gradient y étant disposées au voisinage des première et deuxième bobines solénoïdales (11, 12) de gradient z, à des positions symétriques radialement et longitudinalement par rapport à l'axe Oz, en superposition respectivement aux cinquième, sixième, septième et huitième bobines (21, 22, 23, 24) de gradient x mais décalées de 90° par rapport à celles-ci pour produire une première composante de gradient de champ y dans une deuxième direction radiale y de la machine également perpendiculaire à l'axe Oz, la première direction x étant perpendiculaire à la deuxième direction y ; **en ce que** chacune des treizième et quatorzième bobines solénoïdales (31, 32) de gradient x et y comprend une même pluralité n5 de spires identiques de diamètre inférieur au diamètre interne du tube correspondant (29) et réparties dans des positions prédéterminées selon l'axe de ce tube (29), les spires de la quatorzième bobine (32) disposée en regard de la deuxième bobine (12) étant parcourues par un courant de sens opposé à celui parcourant les spires de la deuxième bobine (12) et à celui parcourant les spires de la treizième bobine (31), elle-même disposée en regard de la première bobine (11), pour produire une deuxième composante à la fois de gradient de champ x et de gradient de champ y.

3. Système de génération de gradients selon la revendication 1 ou la revendication 2, **caractérisé en ce que** les première et deuxième bobines solénoïdales (11, 12) de gradient z et les troisième et quatrième bobines solénoïdales (14, 15) de gradient z sont monocouches.

4. Système de génération de gradients selon l'une quelconque des revendications 1 à 3, **caractérisé en ce que** les cinquième, sixième, septième et huitième bobines (21, 22, 23, 24) de gradient x et les neuvième, dixième, onzième et douzième bobines (25, 26, 27, 28) de gradient y sont monocouches tandis que les treizième et quatorzième bobines solénoïdales (31, 32) de gradient x et y sont bicouches.

5. Système de génération de gradients selon l'une quelconque des revendications 1 à 4, **caractérisé en ce que** les N2 deuxièmes tubes (29) sont plus courts que les N1 premiers tubes (13).

6. Système de génération de gradients selon l'une quelconque des revendications 1 à 5, **caractérisé en ce qu'**il comprend dans le sous-espace cylindrique (9) une couronne de 12, 16 ou 24 tubes comprenant lesdits deuxièmes tubes (29) alternant avec lesdits premiers tubes (13).

7. Machine d'imagerie par résonance magnétique nucléaire à gradients améliorés, comprenant un tunnel (4) d'axe Oz et de section essentiellement circulaire définissant un volume d'intérêt (ZI), un premier espace annulaire cylindrique (1) entourant ledit volume d'intérêt (ZI) et comprenant un système (8) de génération de gradients de champ magnétique pour créer un gradient de champ magnétique dans ledit volume d'intérêt (ZI), un deuxième espace annulaire cylindrique (2) extérieur formant cryostat entourant ledit premier espace annulaire cylindrique (1) et comprenant un dispositif d'aimant supraconducteur pour générer une composante de champ magnétique homogène Bz selon ledit axe Oz dans ledit volume d'intérêt (ZI), un dispositif (3) d'antennes d'émission radiofréquence disposé à l'intérieur dudit tunnel (4) ou au voisinage de celui-ci dans le premier espace annulaire cylindrique (1) et des dispositifs (6) d'alimentation électrique du système (8) de génération de gradients et du dispositif (3) d'antennes, **caractérisée en ce que** le système (8) de génération de gradients est réalisé selon l'une quelconque des revendications 1 à 6.

8. Machine selon la revendication 7, **caractérisée en ce que** le tunnel (4) présente un diamètre de 55 cm, le deuxième espace annulaire cylindrique (2) extérieur présente un diamètre interne de 90 cm, et ledit sous-espace annulaire cylindrique (9) présente un diamètre intérieur de 60 cm.

**9.** Procédé de réalisation d'un système de génération de gradients de champ magnétique, disposé dans un premier espace annulaire cylindrique (1) autour d'un tunnel (4) d'axe Oz et de section essentiellement circulaire définissant un volume d'intérêt (ZI) dans une machine (7) d'imagerie par résonance nucléaire comprenant un deuxième espace annulaire cylindrique (2) extérieur formant cryostat entourant ledit premier espace annulaire cylindrique (1) et comprenant un dispositif d'aimant supraconducteur pour générer une composante de champ magnétique homogène Bz selon ledit axe Oz dans ledit volume d'intérêt (ZI), pour créer un gradient de champ magnétique dans ledit volume d'intérêt (ZI), ledit procédé comprenant les étapes suivantes :

- former à l'intérieur dudit premier espace annulaire cylindrique (1),
- former à l'intérieur dudit premier espace annulaire cylindrique (1), au moins des première et deuxième bobines (11, 12) solénoïdales de gradient z, d'axe Oz parcourues par des courants de sens opposés, pour produire une première composante de gradient de champ z dans une direction axiale z parallèle à l'axe z ;
- former un ensemble de N1 premiers tubes (13) non jointifs identiques de gradient z d'axes parallèles à l'axe Oz et disposés dans un sous-espace annulaire cylindrique (9) situé à l'intérieur dudit premier espace annulaire cylindrique (1) à l'extérieur desdites première et deuxième bobines (11, 12) de gradient z, comprenant chacun au moins des troisième et quatrième bobines (14, 15) solénoïdales de gradient z symétriques par rapport à un plan xOy perpendiculaire à l'axe Oz et parcourues par des courants de sens opposés
- former au moins des cinquième à huitième bobines (21, 22, 23, 24) de gradient x en forme de selle de cheval disposées autour des première et deuxième bobines (11, 12) de gradient z, à des positions symétriques radialement et longitudinalement par rapport à l'axe Oz pour produire une première composante de gradient de champ x dans une première direction radiale x de la machine perpendiculaire à l'axe Oz ;
- former au moins des neuvième à douzième bobines (25, 26, 27, 28) de gradient y en forme de selle de cheval disposées autour des première et deuxième bobines (11, 12) de gradient z, à des positions symétriques radialement et longitudinalement par rapport à l'axe Oz, en superposition respectivement aux cinquième, sixième, septième et huitième bobines (21, 22, 23, 24) de gradient x mais décalées de 90° par rapport à celles-ci pour produire une première composante de gradient de champ y dans une deuxième direction radiale y de la machine également perpendiculaire à l'axe Oz, la première direction x étant perpendiculaire à la deuxième direction y;
- former un ensemble de N2 deuxièmes tubes (29) non jointifs identiques de gradients x et y d'axes parallèles à l'axe Oz et situés dans ledit sous-espace annulaire cylindrique (9) situé à l'intérieur dudit premier espace annulaire cylindrique (1) à l'extérieur des premières et deuxièmes bobines (11, 12) de gradient z, en étant intercalés entre les premiers tubes (13) de gradient z, chacun des N2 deuxièmes tubes (29) de gradient x et y comprenant au moins des treizième et quatorzième bobines (31, 32) solénoïdales parcourues par des courants de sens opposés et symétriques par rapport à un plan xOy perpendiculaire à l'axe Oz, les directions x et y étant orthogonales entre elles et orthogonales à l'axe z ; et déterminer des caractéristiques de l'ensemble des bobines solénoïdales à l'aide du développement en harmoniques sphériques solides réguliers de la composante Bz du champ magnétique créé dans la zone d'intérêt (ZI) par chaque spire ou arc de spire d'une bobine solénoïdales, en fonction d'une puissance disponible d'une alimentation électrique des bobines, du diamètre externe du tunnel (4) définissant la zone d'intérêt (ZI) et du diamètre interne d'un deuxième espace annulaire cylindrique (2) extérieur comprenant un dispositif d'aimant supraconducteur.

**10.** Procédé selon la revendication 9, **caractérisé en ce que** :

- on forme à l'intérieur dudit premier espace annulaire cylindrique (1), des première et deuxième bobines solénoïdales (11, 12) de gradient z comprenant chacune une même pluralité n1 de spires identiques d'axe Oz et de diamètre inférieur au diamètre externe du premier espace annulaire cylindrique (1), les spires de la deuxième bobine (12) étant parcourues par un courant de sens opposé à celui parcourant les spires de la première bobine (11) pour produire une première composante de gradient de champ z dans une direction axiale z parallèle à l'axe Oz ;
- chacune des troisième et quatrième bobines solénoïdales (14, 15) de gradient z symétriques par rapport à un plan xOy perpendiculaire à l'axe Oz, comprend une même pluralité n2 de spires identiques de diamètre inférieur au diamètre interne du tube correspondant (13) et réparties dans des positions prédéterminées selon l'axe de ce tube (13), les spires de la quatrième bobine (15) disposée en regard de la deuxième bobine (12) étant parcourues par un courant de sens opposé à celui parcourant les spires de la deuxième bobine (12) et à celui parcourant les spires de la troisième bobine (14) elle-même disposée en regard de la première bobine (11) pour produire une deuxième composante de gradient de champ z dans ladite direction axiale z parallèle à l'axe Oz ;
- chacune des cinquième, sixième, septième et huitième bobines de gradient x comprend un nombre $n_3$ de spires;
- chacune des neuvième, dixième, onzième et douzième bobines (25, 26, 27, 28) de gradient y comprend un

nombre $n_4$ de spires; et

- chacune des treizième et quatorzième bobines solénoïdales (31, 32) de gradient x et y symétriques par rapport à un plan xOy perpendiculaire à l'axe Oz, comprend une même pluralité n5 de spires identiques de diamètre inférieur au diamètre interne du tube correspondant (29) et réparties dans des positions prédéterminées selon l'axe de ce tube (29), les spires de la quatorzième bobine (32) disposée en regard de la deuxième bobine (12) étant parcourues par un courant de sens opposé à celui parcourant les spires de la deuxième bobine (12) et à celui parcourant les spires de la treizième bobine (31), elle-même disposée en regard de la première bobine (11) pour produire une deuxième composante à la fois de gradient de champ x et de gradient de champ y.

**Patentansprüche**

1. System zur Erzeugung von Magnetfeldgradienten, das in einem ersten zylindrischen ringförmigen Raum (1) um einen Tunnel (4) mit einer Achse Oz und einem im Wesentlichen kreisförmigen Querschnitt angeordnet ist, der ein Volumen von Interesse (ZI) in einer Bildgebungsmaschine durch magnetische Kernresonanz (7) definiert, um einen Magnetfeldgradienten in dem Volumen von Interesse (ZI) zu erzeugen, wobei das System innerhalb des ersten zylindrischen ringförmigen Raums (1) mindestens eine erste und eine zweite Solenoidspule (11, 12) mit einem Gradienten z einer Achse Oz umfasst, die von Strömen in entgegengesetzten Richtungen durchströmt werden; eine Einheit von N1 ersten identischen nicht berührenden Rohren (13) mit einem Gradienten z mit Achsen parallel zur Achse Oz, die in einem zylindrischen ringförmigen Unterraum (9), der sich innerhalb des ersten zylindrischen ringförmigen Raums (1) außerhalb der ersten und zweiten Spulen (11, 12) mit einem Gradienten z befindet, angeordnet sind, wobei jedes der N1 ersten Rohre (13) mindestens dritte und vierte Solenoidspulen (14, 15) umfasst, die von Strömen in entgegengesetzten Richtungen durchströmt werden; mindestens fünfte bis achte Spulen (21, 22, 23, 24) mit einem Gradienten x in Form eines Pferdesattels und neunte bis zwölfte Spulen (25, 26, 27, 28) mit einem Gradienten y in Form eines Pferdesattels, die um die ersten und zweiten Spulen (11, 12) mit einem Gradienten z angeordnet sind; eine Einheit von N2 zweiten identischen nicht berührenden Rohren (29) mit Gradienten x und y mit Achsen parallel zur Achse Oz, die sich in dem zylindrischen ringförmigen Unterraum (9) außerhalb der ersten und zweiten Spulen (11, 12) mit einem Gradienten z befinden, wobei sie zwischen den ersten Rohren (13) mit einem Gradienten Z in dem zylindrischen ringförmigen Unterraum (9) zwischengefügt sind, wobei jedes der zweiten Rohre (29) mit einem Gradienten x und y mindestens dreizehnte und vierzehnte Solenoidspulen (31, 32) umfasst, die von Strömen in entgegengesetzten Richtungen durchströmt werden, wobei die Richtungen x und y orthogonal zueinander und orthogonal zur Achse Oz sind, wobei die ersten und zweiten Spulen (11, 12) zu einer Ebene xOy senkrecht auf die Achse Oz symmetrisch sind, wobei die dritten und vierten Spulen (14, 15) zu dieser Ebene xOy symmetrisch sind, wobei die fünften bis achten Spulen (21, 22, 23, 24) einerseits und die neunten bis zwölften Spulen (25, 26, 27, 28) andererseits ebenfalls zu dieser Ebene xOy symmetrisch sind, und die dreizehnten und vierzehnten Spulen (31, 32) ebenfalls zu dieser Ebene xOy symmetrisch sind.

2. System zur Erzeugung von Magnetfeldgradienten gemäß Anspruch 1, **dadurch gekennzeichnet, dass** jede der ersten und zweiten Solenoidspulen (11, 12) mit einem Gradienten z eine selbe Vielzahl n1 von identischen Windungen mit einer Achse Oz und einem kleineren Durchmesser als der Außendurchmesser des ersten zylindrischen ringförmigen Raums (1) umfasst, wobei die Windungen der zweiten Spule (12) von einem Strom von entgegengesetzter Richtung zu jenem, der die Windungen der ersten Spule (11) durchströmt, durchströmt werden, um eine erste Feldgradientenkomponente z in einer Axialrichtung z parallel zur Achse Oz zu erzeugen; dass jede der dritten und vierten Solenoidspulen (14, 15) mit einem Gradienten z eine selbe Vielzahl n2 von identischen Windungen mit einem kleineren Durchmesser als der Innendurchmesser des entsprechenden Rohrs (13) und in vorbestimmten Positionen entlang der Achse dieses Rohrs (13) verteilt umfasst, wobei die Windungen der vierten Spule (15), die gegenüber der zweiten Spule (12) angeordnet ist, von einem Strom von entgegengesetzter Richtung zu jenem, der die Windungen der zweiten Spule (12) und zu jenem, der die Windungen der dritten Spule (14) durchströmt, die selbst gegenüber der ersten Spule (11) angeordnet ist, um eine zweite Feldgradientenkomponente z in Axialrichtung z parallel zur Achse Oz zu erzeugen, durchströmt werden; dass jede fünften, sechsten, siebenten und achten Spulen mit einem Gradienten x eine Anzahl n3 von Windungen umfasst, wobei die fünfte, sechste, siebente und achte Spule (21, 22, 23, 24) mit einem Gradienten x in der Nähe der ersten und zweiten Solenoidspulen (11, 12) mit einem Gradienten z an radial und längs zur Achse Oz symmetrischen Positionen angeordnet sind, um eine erste Feldgradientenkomponente x in einer ersten Radialrichtung x der Maschine senkrecht auf die Achse Oz zu erzeugen; dass jede der neunten, zehnten, elften und zwölften Spulen (25, 26, 27, 28) mit einem Gradienten y eine Anzahl n4 von Windungen umfasst, wobei die neunte, zehnte, elfte und zwölfte Spule (25, 26, 27, 28) mit einem Gradienten y in der Nähe der ersten und zweiten Solenoidspulen (11, 12) mit einem Gradienten z an radial und längs zur Achse Oz symmetrischen Positionen in Überlagerung mit der fünften, sechsten, siebenten bzw. achten Spule (21, 22, 23, 24) mit einem Gradienten x, aber um 90° in Bezug zu diesen versetzt, angeordnet sind, um eine erste Feldgradientenkomponente y in einer zweiten Radialrichtung y der Maschine ebenfalls senkrecht auf die Achse Oz zu erzeugen, wobei die erste Richtung x senkrecht auf die zweite Richtung y steht; dass jede der dreizehnten und vierzehnten Solenoidspulen (31, 32) mit einem Gradienten x und y eine selbe Vielzahl n5 von identischen Windungen mit einem kleineren Durchmesser als der Innendurchmesser des entsprechenden Rohrs (29) und in vorbestimmten Positionen entlang der Achse dieses Rohrs (29) verteilt umfasst, wobei die Windungen der vierzehnten Spule (32), die gegenüber der zweiten Spule (12) angeordnet ist, von einem Strom von entgegengesetzter Richtung zu jenem, der die Windungen der zweiten Spule (12) und zu jenem, der die Windungen der dreizehnten Spule (31) durchströmt, die selbst gegenüber der ersten Spule (11) angeordnet ist, durchströmt werden, um eine zweite Komponente sowohl eines Feldgradienten x als auch eines Feldgradienten y zu erzeugen.

3. System zur Erzeugung von Gradienten gemäß Anspruch 1 oder Anspruch 2, **dadurch gekennzeichnet, dass** die ersten und zweiten Solenoidspulen (11, 12) mit dem Gradienten z und die dritten und vierten Solenoidspulen (14, 15) mit dem Gradienten z einschichtig sind.

4. System zur Erzeugung von Gradienten gemäß einem der Ansprüche 1 bis 3, **dadurch gekennzeichnet, dass** die fünfte, sechste, siebente und achte Spule (21, 22, 23, 24) mit dem Gradienten x und die neunte, zehnt, elfte und zwölfte Spule (25, 26, 27, 28) mit dem Gradienten y einschichtig sind, während die dreizehnte und vierzehnte Solenoidspule (31, 32) mit dem Gradienten x und y zweischichtig sind.

5. System zur Erzeugung von Gradienten gemäß einem der Ansprüche 1 bis 4, **dadurch gekennzeichnet, dass** die N2 zweiten Rohre (29) kürzer als die N1 ersten Rohre (13) sind.

6. System zur Erzeugung von Gradienten gemäß einem der Ansprüche 1 bis 5, **dadurch gekennzeichnet, dass** es in dem zylindrischen Unterraum (9) einen Kranz von 12, 16 oder 24 Rohren umfasst, der die zweiten Rohre (29) alternierend mit den ersten Rohren (13) umfasst.

7. Bildgebungsmaschine durch magnetische Kernresonanz mit verbesserten Gradienten, umfassend einen Tunnel (4) mit einer Achse Oz und einem im Wesentlichen kreisförmigen Querschnitt, der ein Volumen von Interesse (ZI) definiert, einen ersten zylindrischen ringförmigen Raum (1), der das Volumen von Interesse (ZI) umgibt, und umfassend ein System (8) zur Erzeugung von Magnetfeldgradienten, um einen Magnetfeldgradienten in dem Volumen von Interesse (ZI) zu erzeugen, wobei ein zweiter zylindrischer ringförmiger äußerer Raum (2), der einen Kryostat bildet, den ersten zylindrischen ringförmigen Raum (1) umgibt und eine supraleitende Magnetvorrichtung umfasst, um eine homogene Magnetfeldkomponente Bz entlang der Achse Oz in dem Volumen von Interesse (ZI) zu erzeugen, eine Vorrichtung (3) von Funkfrequenzsendeantennen, die im Inneren des Tunnels (4) oder in der Nähe desselben in dem ersten zylindrischen ringförmigen Raum (1) angeordnet ist, und Vorrichtungen (6) zur elektrischen Versorgung des Systems (8) zur Erzeugung von Gradienten und der Antennenvorrichtung (3), **dadurch gekennzeichnet, dass** das System (8) zur Erzeugung von Gradienten gemäß einem der Ansprüche 1 bis 6 ausgeführt ist.

8. Maschine gemäß Anspruch 7, **dadurch gekennzeichnet, dass** der Tunnel (4) einen Durchmesser von 55 cm aufweist, der zweite zylindrische ringförmige äußere Raum (2) einen Innendurchmesser von 90 cm aufweist, und der zylindrische ringförmige Unterraum (9) einen Durchmesser unter 60 cm aufweist.

9. Verfahren zur Herstellung eines Systems zur Erzeugung von Magnetfeldgradienten, das in einem ersten zylindrischen ringförmigen Raum (1) um einen Tunnel (4) mit einer Achse Oz und einem im Wesentlichen kreisförmigen Querschnitt angeordnet ist, der ein Volumen von Interesse (ZI) in einer Bildgebungsmaschine durch magnetische Kernresonanz (7) definiert, umfassend einen zweiten äußeren zylindrischen ringförmigen Raum (2), der einen Kryostat bildet, der den ersten zylindrischen ringförmigen Raum (1) umgibt, und umfassend eine supraleitende Magnetvorrichtung, um eine homogene Magnetfeldkomponente Bz entlang der Achse Oz in dem Volumen von Interesse (ZI) zu bilden, um einen Magnetfeldgradienten in dem Volumen von Interesse (ZI) zu erzeugen, wobei das Verfahren die folgenden Schritte umfasst:

- Bildung innerhalb des ersten zylindrischen ringförmigen Raums (1) mindestens einer ersten und einer zweiten Solenoidspule (11, 12) mit einem Gradienten z, einer Achse Oz, die von Strömen in entgegengesetzten Richtungen durchströmt werden, um eine erste Feldgradientenkomponente z in einer Axialrichtung z parallel zur Achse z zu erzeugen;
- Bildung einer Einheit von N1 ersten identischen nicht berührenden Rohren (13) mit einem Gradienten z mit Achsen parallel zur Achse Oz, die in einem zylindrischen ringförmigen Unterraum (9), der sich innerhalb des ersten zylindrischen ringförmigen Raums (1) außerhalb der ersten und zweiten Spulen (11, 12) mit einem Gradienten z befindet, angeordnet sind, umfassend jeweils mindestens dritte und vierte Solenoidspulen (14, 15) mit einem Gradienten z, die zu einer Ebene xOy senkrecht auf die Achse Oz symmetrisch sind und von Strömen in entgegengesetzten Richtungen durchströmt werden;

- Bildung von mindestens fünften bis achten Spulen (21, 22, 23, 24) mit einem Gradienten x in Form eines Pferdesattels, die um die ersten und zweiten Spulen (11, 12) mit einem Gradienten z angeordnet sind, an radial und längs zur Achse Oz symmetrischen Positionen, um eine erste Feldgradientenkomponente x in einer ersten Radialrichtung x der Maschine senkrecht auf die Achse Oz zu erzeugen;

- Bildung von mindestens neunten bis zwölften Spulen (25, 26, 27, 28) mit einem Gradienten y in Form eines Pferdesattels, die um die ersten und zweiten Spulen (11, 12) mit einem Gradienten z angeordnet sind, an radial und längs zur Achse Oz symmetrischen Positionen, in Überlagerung zu den fünften, sechsten, siebenten bzw. achten Spulen (21, 22, 23, 24) mit einem Gradienten x, aber um 90° zu diesen versetzt, um eine erste Feldgradientenkomponente y in einer ersten Radialrichtung y der Maschine ebenfalls senkrecht auf die Achse Oz zu erzeugen, wobei die erste Richtung x senkrecht auf die zweite Richtung y steht;

- Bildung einer Einheit von N2 zweiten identischen nicht berührenden Rohren (29) mit Gradienten x und y mit Achsen parallel zur Achse Oz, die sich in dem zylindrischen ringförmigen Unterraum (9), der sich im Inneren des ersten zylindrischen ringförmigen Raums (1) außerhalb der ersten und zweiten Spulen (11, 12) mit einem Gradienten z befinden, wobei sie zwischen den ersten Rohren (13) mit einem Gradienten z zwischengefügt sind, wobei jedes der N2 zweiten Rohre (29) mit einem Gradienten x und y mindestens dreizehnte und vierzehnte Solenoidspulen (31, 32) umfasst, die von Strömen in entgegengesetzten Richtungen durchströmt werden und zu einer Ebene xOy senkrecht auf die Achse Oz symmetrisch sind, wobei die Richtungen x und y zueinander orthogonal und zur Achse z orthogonal sind; und

- Bestimmung der Merkmale der Gesamtheit der Solenoidspulen mit Hilfe der Entwicklung von regelmäßigen festen sphärischen Harmonischen der Komponente Bz des in der Zone von Interesse (ZI) von jeder Windung oder jedem Windungsbogen einer Solenoidspule erzeugten Magnetfeldes in Abhängigkeit von einer verfügbaren Leistung einer elektrischen Versorgung der Spulen, vom Außendurchmesser des Tunnels (4), der die Zone von Interesse (ZI) definiert, und vom Innendurchmesser eines zweiten äußeren zylindrischen ringförmigen Raums (2), umfassend eine supraleitende Magnetvorrichtung.

**10.** Verfahren gemäß Anspruch 9, **dadurch gekennzeichnet, dass**

- innerhalb des ersten zylindrischen ringförmigen Raums (1) erste und zweite Solenoidspulen (11, 12) mit einem Gradienten z gebildet werden, jeweils umfassend eine selbe Vielzahl n1 von identischen Windungen mit einer Achse Oz und einem kleineren Durchmesser als der Außendurchmesser des ersten zylindrischen ringförmigen Raums (1), wobei die Windungen der zweiten Spule (12) von einem Strom in entgegengesetzter Richtung zu jenem, der die Windungen der ersten Spule (11) durchströmt, durchströmt werden, um eine erste Feldgradientenkomponente z in einer Axialrichtung z parallel zur Achse Oz zu erzeugen;

- jede der dritten und vierten Solenoidspulen (14, 15) mit einem Gradienten z, die zu einer Ebene xOy senkrecht auf die Achse Oz symmetrisch sind, eine selbe Vielzahl n2 von identischen Windungen mit einem kleineren Durchmesser als der Innendurchmesser des entsprechenden Rohrs (13) und in vorbestimmten Positionen entlang der Achse dieses Rohrs (13) verteilt umfasst, wobei die Windungen der vierten Spule (15), die gegenüber der zweiten Spule (12) angeordnet ist, von einem Strom in entgegengesetzter Richtung zu jenem, der die Windungen der zweiten Spule (12) durchströmt, und zu jenem, der die Windungen der dritten Spule (14) durchströmt, die selbst gegenüber der ersten Spule (11) angeordnet ist, durchströmt werden, um eine zweite Feldgradientenkomponente z in Axialrichtung z parallel zur Achse Oz zu erzeugen;

- jede der fünften, sechsten, siebenten und achten Spulen mit dem Gradienten x eine Anzahl n3 von Windungen umfasst;

- jede der neunten, zehnten, elften und zwölften Spulen (25, 26, 27, 28) mit dem Gradienten y eine Anzahl n4 von Windungen umfasst, und

- jede der dreizehnten und vierzehnten Solenoidspulen (31, 32) mit dem Gradienten x und y, die zu einer Ebene xOy senkrecht auf die Achse Oz symmetrisch sind, eine selbe Vielzahl n5 von identischen Windungen mit einem kleineren Durchmesser als der Innendurchmesser des entsprechenden Rohrs (29) und in vorbestimmten Positionen entlang der Achse dieses Rohrs (29) verteilt umfasst, wobei die Windungen der vierzehnten Spule (32), die gegenüber der zweiten Spule (12) angeordnet ist, von einem Strom in entgegengesetzter Richtung zu jenem, der die Windungen der zweiten Spule (12) durchströmt, und zu jenem, der die Windungen der dreizehnten Spule (31) durchströmt, die selbst gegenüber der ersten Spule (11) angeordnet ist, durchströmt werden, um eine zweite Komponente eines Feldgradienten x als auch eines Feldgradienten y zu erzeugen.

**Claims**

1. A magnetic field gradient generator system arranged in a first cylindrical annular space (1) around a tunnel (4) of axis Oz and of essentially circular section defining a volume of interest (ZI) in a nuclear magnetic resonance imaging machine (7), in order to create a magnetic field gradient in said volume of interest (ZI) the system comprising inside the first cylindrical annular space (1) at least solenoidal z-gradient first and second coils (11, 12) of axis Oz carrying currents in opposite directions; a set of N1 identical non-touching z-gradient first tubes (13) of axes parallel to the axis Oz and arranged in a cylindrical annular subspace (9) situated inside said first cylindrical annular space (1) outside said z-gradient first and second coils (11, 12), each of said N1 first tubes (13) comprising at least solenoidal third and fourth coils (14, 15) carrying currents in opposite directions ; at least x-gradient fifth to eighth coils (21, 22, 23, 24) of saddle shape and y-gradient ninth to twelfth coils (25, 26, 27, 28) of saddle shape arranged around the z-gradient first and second coils (11, 12); a set of N2 identical non-touching x and y-gradient second tubes (29) of axes parallel to the axis Oz and situated in said cylindrical annular subspace (9) outside the z-gradient first and second coils (11, 12), being interposed between the z-gradient first tubes (13) in said cylindrical annular subspace (9), each of the x and y-gradient second tubes (29) comprising at least solenoidal thirteenth and fourteenth coils (31, 32) carrying currents in opposite directions, the x and y directions being mutually orthogonal and orthogonal to the axis Oz, the first and second coils (11, 12) being symmetrical relative to a plane xOy perpendicular to said axis Oz, the third and fourth coils (14, 15) being symmetrical relative to the plane xOy, the fifth to eighth coils (21, 22, 23, 24) from one hand and the ninth to twelfth coils (25, 26, 27, 28)from the other hand being also symmetrical relative to the plane xOy and the thirteenth and fourteenth coils (31, 32) being also symmetrical relative to the plane xOy.

2. A magnetic field gradient generator system according to claim 1, **characterized in that** each of the solenoidal z-gradient first and second coils (11, 12) comprises the same plurality n1 of identical turns of axis Oz and of diameter less than the outside diameter of the first cylindrical annular space (1), the turns of the second coil (12) carrying current in a direction opposite to the direction of current carried by the turns of the first coil (1) in order to produce a first z-gradient field component in an axial direction z parallel to the axis Oz; **in that** each of the solenoidal z-gradient third and fourth coils (14, 15) comprises the same plurality n2 of identical turns of diameter less than the inside diameter of the corresponding tube (13) and distributed in predetermined positions along the axis of the tube (13), the turns of the fourth coil (15) arranged facing the second coil (12) carrying current in a direction opposite to the direction of current carried by the turns of the second coil (12) and to the direction of current carried by the turns of the third coil (14), itself arranged facing the first coil (11) in order to produce a second z-gradient field component in said axial direction z parallel to the axis Oz ; **in that** each of the x-gradient fifth, sixth, seventh, and eighth coils has a n3 of turns, the x-gradient fifth, sixth, seventh, and eighth coils (21, 22, 23, 24) being arranged in the vicinity of the solenoidal z-gradient first and second coils (11, 12) in positions that are radially and longitudinally symmetrical relative to the axis Oz in order to produce a first x-gradient field component in a first radial direction x of the machine perpendicular to the axis Oz; **in that** each of the y-gradient ninth, tenth, eleventh, and twelfth coils (25, 26, 27, 28) has a number n4 of turns, the y-gradient ninth, tenth, eleventh, and twelfth coils (25, 26, 27, 28) being arranged in the vicinity of the solenoidal z-gradient first and second coils (11, 12) in positions that are radially and longitudinally symmetrical relative to the axis Oz, in superposition respectively with the x-gradient fifth, sixth, seventh, and eighth coils (21, 22, 23, 24) but offset at 90° relative to thereto in order to produce a first y-gradient field component in a second radial direction y of the machine likewise perpendicular to the axis Oz, the first direction x being perpendicular to the second direction y; **in that** each of solenoidal x and y-gradient thirteenth and fourteenth coils (31, 32) comprises the same plurality n5 of identical turns of diameter less than the inside diameter of the corresponding tube (29) and distributed in predetermined positions along the axis of this tube (29), the turns of the fourteenth coil (32) arranged facing the second coil (12) carrying current in a direction opposite to the direction of current carried by the turns of the second coil (12) and to the direction of current carried by the turns of the thirteenth coil (31) itself arranged facing the first coil (11) in order to produce a second field component having both an x gradient and a y gradient.

3. A gradient generator system according to claim 1 or claim 2, **characterized in that** the solenoidal z-gradient first and second coils (11, 12) and the solenoidal z-gradient third and fourth coils (14, 15) are single-layer coils.

4. A gradient generator system according to any one of claims 1 to 3, **characterized in that** the x-gradient fifth, sixth, seventh, and eighth coils (21, 22, 23, 24) and the y-gradient ninth, tenth, eleventh, and twelfth coils (25, 26, 27, 28) are single-layer coils, while the solenoidal x and y-gradient thirteenth and fourteenth coils (31, 32) are two-layer coils.

5. A gradient generator system according to any one of claims 1 to 4, **characterized in that** the N2 second tubes (29) are shorter than the N1 first tubes (13).

**6.** A gradient generator system according to any one of claims 1 to 5, **characterized in that**, in the cylindrical sub-space (9) it comprises a ring of 12, 16, or 24 tubes made up of said second tubes (29) alternating with said first tubes (13).

**7.** A nuclear magnetic resonance imaging machine with improved gradients, comprising a tunnel (4) of axis Oz and of essentially circular section defining a volume of interest (ZI), a first cylindrical annular space (1) surrounding said volume of interest (ZI) and containing a magnetic field gradient generator system (8) for creating a magnetic field gradient in said volume of interest (ZI), an outer second cylindrical annular space (2) forming a cryostat surrounding said first cylindrical annular space (1) and including a superconductive magnet device for generating a uniform magnetic field component $B_z$ along said axis Oz in said volume of interest (ZI), a radio frequency emission antenna device (3) arranged inside said tunnel (4) or in the vicinity thereof in the first cylindrical annular space (1), and electrical power supply devices (6) for powering the gradient generator system (8) and the antenna device (3), the machine being **characterized in that** the gradient generator system (8) is a system according to any one of claims 1 to 6.

**8.** A machine according to claim 7, **characterized in that** the tunnel (4) presents a diameter of 55 cm, the outer second cylindrical annular space (2) presents an inside diameter of 90 cm, and said cylindrical annular sub-space (9) presents an inside diameter of 60 cm.

**9.** A method of providing a magnetic field gradient system arranged in a first cylindrical annular space (1) around a tunnel (4) of axis Oz and of essentially circular section defining a volume of interest (ZI) in a nuclear resonance imaging machine (7) comprising a second cylindrical annular space (2) forming a cryostat surrounding said first cylindrical annular space (1) and including a superconductive magnet device for generating a uniform magnetic field component $B_z$ along said axis Oz in said volume of interest (ZI) in order to create a magnetic field gradient in said volume of interest (ZI), the method comprising the following steps:

• forming inside said first cylindrical annular space (1) at least solenoidal z-gradient first and second coils (11, 12) of axis Oz carrying currents in opposite directions to produce a first z-gradient field component in an axial direction z-parallel to the axis z ;

• forming a set of N1 non-joining identical z-gradient first tubes (13) parallel to the axis Oz, arranged in a cylindrical annular subspace (9) situated inside said first cylindrical annular space (1) outside said z-gradient first and second coils (11, 12), each comprising at least z-gradient solenoidal third and fourth coils (14, 15) symmetrical relative to a plane xOy perpendicular to axis $O_z$ and carrying currents in opposite directions ;

• forming at least x-gradient fifth to eighth coils (21, 22, 23, 24) of saddle shape arranged around the z-gradient first and second coils (11, 12) in positions that are radially and longitudinally symmetrical relative to the axis Oz in order to produce a first x-gradient field component in a first radial direction x of the machine perpendicular to the axis Oz;

• forming at least y-gradient ninth to twelfth coils (25, 26, 27, 28) of saddle shape arranged around the z-gradient first and second coils (11, 12) at positions that are radially and longitudinally symmetrical relative to the axis Oz, in superposition respectively with the x-gradient fifth, sixth, seventh, and eighth coils (21, 22, 23, 24) but offset by 90° relative thereto in order to produce a first y-gradient field component in a second radial direction y of the machine that is likewise perpendicular to the axis Oz, the first direction x being perpendicular to the second direction y;

• forming a set of N2 non-joining identical x and y-gradient second tubes (29) of axes parallel to the axis Oz and situated in the cylindrical annular subspace (9) situated inside the first cylindrical annular space (1) outside the z-gradient first and second coils (11, 12), being interposed between the z-gradient first tubes (13), each of the N2 x and y-gradient second tubes (29) comprising at least solenoidal thirteenth and fourteenth coils (31, 32) carrying currents in opposite directions and symmetrical relative to a plane xOy perpendicular to axis Oz, the directions x and y being mutually orthogonal and orthogonal to the axis Oz; and

• determining characteristics of all of the solenoidal coils with the help of the regular solid spherical harmonic development of the component $B_z$ of the magnetic field created in the zone of interest (ZI) for each turn or turn arc of a solenoidal coil as a function of a power available for electrically powering the coils, of the outside diameter of the tunnel (4) defining the zone of interest (ZI), and of the inside diameter of an outer second cylindrical annular space (2) including a superconductive magnet device.

**10.** A method according to claim 9 **characterized in that** :

• inside said first cylindrical annular space (1) solenoidal z-gradient first and second coils (11, 12)are formed, each comprising the same plurality n1 of identical turns of axis Oz and of diameter less than the outside diameter of the first cylindrical annular space (1), the turns of the second coil (12) carrying current in a direction opposite to the direction of current carried by the turns of the first coil (11) in order to produce a first z-gradient field component in an axial direction z parallel to the axis Oz;

• each of the solenoidal z-gradient third and fourth coils (14, 15) that are symmetrical relative to a plane xOy perpendicular to the axis Oz comprises a same plurality n2 of identical turns of diameter less than the inside diameter of the corresponding tube (13) and distributed in predetermined positions along the axis of this tube (13), the turns of the fourth coil (15) arranged facing the second coil (12) carrying current in a direction opposite to the direction of current carried by the turns of the second coil (12) and to the direction of current carried by the turns of the third coil (14), itself arranged facing the first coil (11) in order to produce a second z-gradient field component in said axial direction z parallel to the axis Oz;

• each of the x-gradient fifth, sixth, seventh, and eighth coils has a number n3 of turns ;

• each of the y-gradient ninth, tenth, eleventh, and twelfth coils (25, 26, 27, 28) has a number n4 of turns ;

• each of the thirteenth and fourteenth coils (31, 32) that are symmetrical relative to an xOy plane perpendicular to the axis Oz, each comprising the same plurality n5 of identical turns of diameter less than the inside diameter of the corresponding tubes (29) and distributed in predetermined positions along the axis of this tube (29), the turns of the fourteenth coil (32) arranged facing the second coil (12) carrying current in a direction opposite to the direction of current carried by the turns of the second coil (12) and to the direction of current carried by the turns of the thirteenth coil (31), itself arranged facing the first coil (11), in order to produce a second field component having both an x gradient and a y gradient.

EP 2 739 985 B1

FIG.1

FIG.1A

22

FIG.2

FIG.2A

EP 2 739 985 B1

# FIG.3

# FIG.4

EP 2 739 985 B1

FIG.5A

FIG.5

FIG.6

FIG.7

FIG.8

21,22,25,26

23,24,27,28

32

31

n5

n5

FIG.9

FIG.10

**FIG.11**

41

**FIG.12**

42

EP 2 739 985 B1

51

**FIG.13**

52

**FIG.14**

53

**FIG.15**

54

**FIG.16**

FIG.17

55

FIG.18

56

**FIG.19**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 221810 A
- WO 8903031 A
- WO 2005029110 A
- WO 2007048983 A
- WO 2005029110 A2
- EP 0221810 A1
- US 4617516 A
- EP 0140259 B1
- WO 2007048983 A2